(19) Europäisches Patentamt
European Patent Office
Office européen des brevets

(11) **EP 4 191 873 A1**

(12) **EUROPEAN PATENT APPLICATION**

(43) Date of publication:
**07.06.2023 Bulletin 2023/23**

(21) Application number: **22211638.6**

(22) Date of filing: **06.12.2022**

(51) International Patent Classification (IPC):
**H03F 1/32** (2006.01)

(52) Cooperative Patent Classification (CPC):
**H03F 1/3247; H03F 1/3258**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **06.12.2021 US 202117542734**

(71) Applicant: **Sumitomo Electric Device Innovations, Inc.**
**Yokohama-shi, Kanagawa, 224-0845 (JP)**

(72) Inventors:
• **Yang, Ruikang**
  **Bridgewater, NJ (US)**
• **Russo, Michael**
  **Morris Plains, NJ (US)**
• **Hamparian, Simon**
  **Emerson, NJ (US)**

(74) Representative: **Grünecker Patent- und Rechtsanwälte**
**PartG mbB**
**Leopoldstraße 4**
**80802 München (DE)**

(54) **DUAL-LAYERED PREDISTORTION SYSTEM FOR WIRELESS COMMUNICATION**

(57)    Various embodiments of the present disclosure relate to transmitter systems, methods, and instructions for signal predistortion. The transmitter system includes a primary digital predistortion (DPD) layer and a secondary DPD layer. The primary DPD layer includes a DPD coefficient estimation module configured to update primary signal generation coefficients based on comparing a secondary predistorted signal ($U_{out}$) with a detected feedback signal ($Y_{out}$), and a primary distortion compensation processing module configured to generate a primary predistorted signal ($U_{out}'$) based on the secondary predistorted signal ($U_{out}$) using the updated primary signal generation coefficients. The secondary DPD layer includes a signal characteristic estimation module configured to update secondary signal generation coefficients based on comparing an input signal ($S_{in}$) with the detected feedback signal ($Y_{out}$), and a secondary distortion compensation processing module configured to generate the secondary predistorted signal ($U_{out}$) based on the input signal ($S_{in}$) using the updated secondary signal generation coefficients.

Fig.2

EP 4 191 873 A1

**Description**

Field of the disclosure

The present disclosure relates generally to distortion compensation for an amplifier and, more particularly, to a system and method for compensating for amplifier distortion.

Background of the disclosure

Amplifiers can have non-linear characteristics. Distortion compensation techniques are used for compensating for distortions in signals caused by the non-linear characteristics. An instantaneous change in distortion may occur in a GaN amplifier, for example. Such distortions can degrade the bit-error rate (BER) performance of the amplifier.

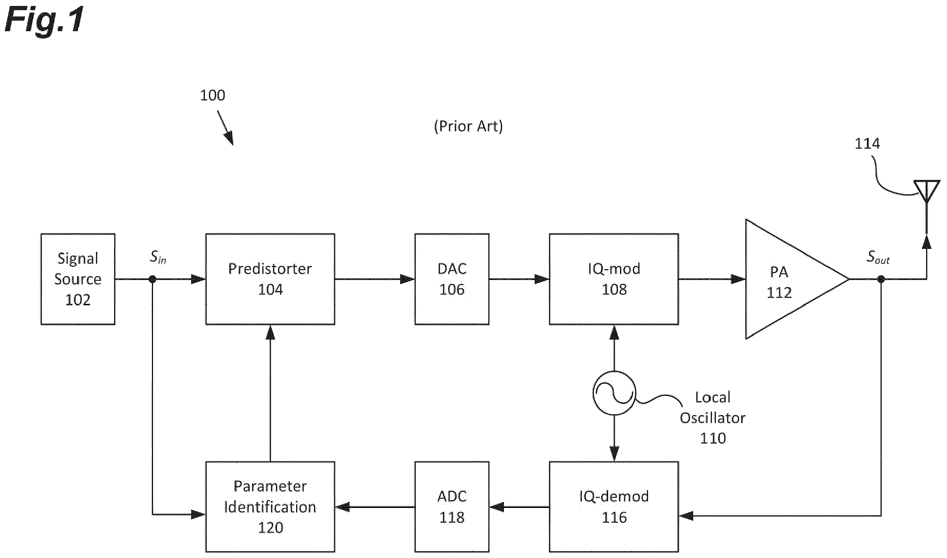

Fig. 1 illustrates a prior art system 100 for performing distortion compensation which implements a predistorter and a parameter identification module therefor. The system 100 includes a signal source 102 which provides a digital input signal ($S_{in}$) that is initially provided to a digital-analog converter (DAC) 106 to be converted into an analog radiofrequency (RF) input signal. An in-phase/quadrature (IQ) signal modulator 108 performs IQ modulation on the RF input signal based on a predetermined frequency of a local oscillator 110 to provide a signal to be amplified by a power amplifier (PA) 112, the resulting signal of which is an output signal ($S_{out}$) to be transmitted through an antenna 114.

In the prior art system 100, the change in distortion in the PA 112 is dealt with by updating distortion compensation coefficients implemented in a distortion compensation device in response to the change in the distortion. Specifically, the output signal ($S_{out}$) is provided via a feedback loop to an IQ signal demodulator 116, using the same frequency of the local oscillator 110 as the IQ modulator 108, and the demodulated signal is provided to the analog-digital converter (ADC) 118 to be provided to a parameter identification module 120, which is part of the distortion compensation device. The parameter identification module 120 receives the input signal ($S_{in}$) and compares it to the received signal from the ADC 118, then updates the distortion compensation coefficients to be used by a predistorter module 104, also part of the distortion compensation device, such that the output signal to be provided to the DAC 106 would be predistorted to accommodate for the distortion caused by the PA 112.

The predistorter module 104, known in the art, is implemented in the digital baseband domain and generates a complementary nonlinearity to that of the PA 112. The predistorted baseband signal is upconverted to the RF signal via the IQ modulator 108 and then feed to the PA 112. To synthesize the predistorter function, a portion of the signal from the PA 112 is extracted and down-converted via the IQ demodulator 116 to be used to estimate the parameters of a predistorter model.

By updating the distortion compensation coefficients, distortion compensation characteristics of the distortion compensation device are updated in response to the change in the distortion. In order to follow an instantaneous change in distortion, it is necessary to perform frequent updating of the distortion compensation characteristics. Since a processing load for updating the distortion compensation characteristics is great, however, it is not always easy to frequently update the distortion compensation characteristics in preparation for a change in distortion. Therefore, an improved technique for dealing with a change in distortion is desired.

Summary of the disclosure

Various embodiments of the present disclosure relate to transmitter systems for signal predistortion, including the embodiment of the system described in this paragraph. The transmitter system includes a primary digital predistortion (DPD) layer and a secondary DPD layer. The primary DPD layer includes a DPD coefficient estimation module configured to update primary signal generation coefficients based on comparing a secondary predistorted signal ($U_{out}$) with a detected feedback signal ($Y_{out}$), and a primary distortion compensation processing module configured to generate a primary predistorted signal ($U_{out}'$) based on the secondary predistorted signal ($U_{out}$) using the updated primary signal generation coefficients. The secondary DPD layer includes a signal characteristic estimation module configured to update secondary signal generation coefficients based on comparing an input signal ($S_{in}$) with the detected feedback signal ($Y_{out}$), and a secondary distortion compensation processing module configured to generate the secondary predistorted signal ($U_{out}$) based on the input signal ($S_{in}$) using the updated secondary signal generation coefficients, wherein preferably the primary DPD layer is configured to update the primary signal generation coefficients by performing direct or indirect learning, and the secondary DPD layer is configured to update the secondary signal generation coefficients by performing direct learning.

In some examples, the direct learning includes comparing the input signal ($S_{in}$) with an output signal ($S_{out}$) from an amplifier to determine a difference between the input and output signals; and applying inverse modeling to update the primary or secondary signal generation coefficients in order to reduce the difference between the input and output signals. In some examples, the indirect learning includes comparing the input signal ($S_{in}$) with an output signal ($S_{out}$)

2

from an amplifier to determine an error signal; decomposing the error signal into nonlinear terms; and applying adaptive model learning to update the primary signal generation coefficients by subtracting the nonlinear terms of the error signal from the secondary predistorted signal ($U_{out}$).

Also disclosed herein are methods for performing signal predistortion, including the embodiment of the method described in this paragraph. The method includes updating, by a signal characteristic estimation module of a secondary DPD layer, secondary signal generation coefficients based on comparing an input signal ($S_{in}$) with a detected feedback signal ($Y_{out}$); generating, by a secondary distortion compensation processing module of the secondary DPD layer, a secondary predistorted signal ($U_{out}$) based on the input signal ($S_{in}$) using the updated secondary signal generation coefficients; updating, by a DPD coefficient estimation module of a primary DPD layer, primary signal generation coefficients based on comparing the secondary predistorted signal ($U_{out}$) with the detected feedback signal ($Y_{out}$), and generating, by a primary distortion compensation processing module of the primary DPD layer, a primary predistorted signal ($U_{out}'$) based on the secondary predistorted signal ($U_{out}$) using the updated primary signal generation coefficients, wherein preferably the primary signal generation coefficients are updated by performing direct or indirect learning, and the secondary signal generation coefficients are updated by performing indirect learning.

In some examples, the method includes performing the direct learning by comparing the input signal ($S_{in}$) with an output signal ($S_{out}$) from an amplifier to determine a difference between the input and output signals; and applying inverse modeling to update the primary or secondary signal generation coefficients in order to reduce the difference between the input and output signals. In some examples, the method includes performing the indirect learning by comparing the input signal ($S_{in}$) with an output signal ($S_{out}$) from an amplifier to determine an error signal; decomposing the error signal into nonlinear terms; and applying adaptive model learning to update the primary signal generation coefficients by subtracting the nonlinear terms of the error signal from the secondary predistorted signal ($U_{out}$).

Also disclosed herein are transmitter systems, including the embodiment of the system described in this paragraph, each with an intermodulation distortion filter module configured to filter a detected feedback signal ($Y_{in}$) to generate a targeted filtered signal ($Y_{out}$), a primary DPD layer, and a secondary DPD layer. The primary DPD layer includes a DPD coefficient estimation module configured to update primary signal generation coefficients based on comparing a secondary predistorted signal ($U_{out}$) with a targeted filtered signal ($Y_{out}$), and a primary distortion compensation processing module configured to generate a primary predistorted signal ($U_{out}'$) based on the secondary predistorted signal ($U_{out}$) using the updated primary signal generation coefficients. The secondary DPD layer includes a signal characteristic estimation module configured to update secondary signal generation coefficients based on comparing an input signal ($S_{in}$) with a targeted filtered signal ($Y_{out}$), and a secondary distortion compensation processing module configured to generate the secondary predistorted signal ($U_{out}$) based on the input signal ($S_{in}$) using the updated secondary signal generation coefficients, wherein preferably the primary DPD layer is configured to update the primary signal generation coefficients by performing direct or indirect learning, and the secondary DPD layer is configured to update the secondary signal generation coefficients by performing indirect learning.

Also disclosed herein are methods for performing signal predistortion, including the embodiment of the method described in this paragraph, where each method includes filtering, by an intermodulation distortion filter module, a detected feedback signal ($Y_{in}$) to generate a targeted filtered signal ($Y_{out}$); updating, by a signal characteristic estimation module of a secondary DPD layer, secondary signal generation coefficients based on comparing an input signal ($S_{in}$) with a targeted feedback signal ($Y_{out}$); generating, by a secondary distortion compensation processing module of the secondary DPD layer, a secondary predistorted signal ($U_{out}$) based on the input signal ($S_{in}$) using the updated secondary signal generation coefficients; updating, by a DPD coefficient estimation module of a primary DPD layer, primary signal generation coefficients based on comparing the secondary predistorted signal ($U_{out}$) with the targeted feedback signal ($Y_{out}$), and generating, by a primary distortion compensation processing module of the primary DPD layer, a primary predistorted signal ($U_{out}'$) based on the secondary predistorted signal ($U_{out}$) using the updated primary signal generation coefficients, wherein preferably the primary signal generation coefficients are updated by performing direct or indirect learning, and the secondary signal generation coefficients are updated by performing indirect learning.

Also disclosed herein are embodiments of at least one non-transitory computer-readable medium storing instructions therein which, when run on a processor, causes the processor to carry out the method outlined above.

Also disclosed herein are transmitter systems, including the embodiment of the system described in this paragraph, each with a signal decomposition module, a low-frequency primary DPD layer, a high-frequency primary DPD layer, a signal combining module, a low-frequency secondary DPD layer, and a high-frequency secondary DPD layer. The signal decomposition module is configured to extract a low-frequency input signal ($S_{lo}$) and a high-frequency input signal ($S_{hi}$) from an input signal ($S_{in}$). The low-frequency primary DPD layer includes a low-frequency DPD coefficient estimation module configured to update low-frequency primary signal generation coefficients based on a low-frequency secondary predistorted signal ($U_{lo}$), a high-frequency secondary predistorted signal ($U_{hi}$), and a low-frequency detected feedback signal ($Y_{lo}$), and a low-frequency primary distortion compensation processing module configured to generate a low-frequency primary predistorted signal ($U_{lo}'$) based on the low-frequency secondary predistorted signal ($U_{lo}$) and a high-frequency secondary predistorted signal ($U_{hi}$) using the updated low-frequency primary signal generation coefficients. The high-frequency primary DPD layer includes a high-frequency DPD coefficient estimation module configured to update high-frequency primary signal generation coefficients based on the low-frequency secondary predistorted signal ($U_{lo}$), the high-frequency secondary predistorted signal ($U_{hi}$), and a high-frequency detected feedback signal ($Y_{hi}$), and a high-frequency primary distortion compensation processing module configured to generate a high-frequency primary predistorted signal ($U_{hi}$') based on the low-frequency secondary predistorted signal ($U_{lo}$) and the high-frequency secondary predistorted signal ($U_{hi}$) using the updated high-frequency primary signal generation coefficients. The signal combining module is configured to combine the low-frequency primary predistorted signal ($U_{lo}$') and the high-frequency primary predistorted signal ($U_{hi}$'). The low-frequency secondary DPD layer includes a low-frequency signal characteristic estimation module configured to update low-frequency secondary signal generation coefficients based on the low-frequency input signal ($S_{lo}$), the high-frequency input signal ($S_{hi}$), and the detected low-frequency feedback signal ($Y_{lo}$), and a low-frequency secondary distortion compensation processing module configured to generate the low-frequency secondary predistorted signal ($U_{lo}$) based on the low-frequency input signal ($S_{lo}$) and the high-frequency input signal ($S_{hi}$) using the updated low-frequency secondary signal generation coefficients. The high-frequency secondary DPD layer includes a high-frequency signal characteristic estimation module configured to update high-frequency secondary signal generation coefficients based on the low-frequency input signal ($S_{lo}$), the high-frequency input signal ($S_{hi}$), and the detected high-frequency feedback signal ($Y_{hi}$), and a high-frequency secondary distortion compensation processing module configured to generate the high-frequency secondary predistorted signal ($U_{hi}$) based on the low-frequency input signal ($S_{lo}$) and the high-frequency input signal ($S_{hi}$) using the updated high-frequency secondary signal generation coefficients.

Also disclosed herein are methods for performing signal predistortion, including the embodiment of the method described in this paragraph, where each method includes extracting, by a signal decomposition module, a low-frequency input signal ($S_{lo}$) and a high-frequency input signal ($S_{hi}$) from an input signal ($S_{in}$); updating, by a low-frequency signal characteristic estimation module of a low-frequency secondary DPD layer, low-frequency secondary signal generation coefficients based on the low-frequency input signal ($S_{lo}$), the high-frequency input signal ($S_{hi}$), and a low-frequency detected feedback signal ($Y_{lo}$); generating, by a low-frequency secondary distortion compensation processing module of the low-frequency secondary DPD layer, a low-frequency secondary predistorted signal ($U_{lo}$) based on the low-frequency input signal ($S_{lo}$) and the high-frequency input signal ($S_{hi}$) using the updated low-frequency secondary signal generation coefficients; updating, by a high-frequency signal characteristic estimation module of a high-frequency secondary DPD layer, high-frequency secondary signal generation coefficients based on the low-frequency input signal ($S_{lo}$), the high-frequency input signal ($S_{hi}$), and a high-frequency detected feedback signal ($Y_{hi}$); generating, by a high-frequency secondary distortion compensation processing module of the high-frequency secondary DPD layer, a high-frequency secondary predistorted signal ($U_{hi}$) based on the low-frequency input signal ($S_{lo}$) and the high-frequency input signal ($S_{hi}$) using the updated high-frequency secondary signal generation coefficients; updating, by a low-frequency DPD coefficient estimation module of a low-frequency primary DPD layer, low-frequency primary signal generation coefficients based on a low-frequency secondary predistorted signal ($U_{lo}$), a high-frequency secondary predistorted signal ($U_{hi}$), and the low-frequency detected feedback signal ($Y_{lo}$); generating, by a low-frequency primary distortion compensation processing module of the low-frequency primary DPD layer, a low-frequency primary predistorted signal ($U_{lo}$') based on the low-frequency secondary predistorted signal ($U_{lo}$) and a high-frequency secondary predistorted signal ($U_{hi}$) using the updated low-frequency primary signal generation coefficients; updating, by a high-frequency DPD coefficient estimation module of a high-frequency primary DPD layer, high-frequency primary signal generation coefficients based on the low-frequency secondary predistorted signal ($U_{lo}$), the high-frequency secondary predistorted signal ($U_{hi}$), and the high-frequency detected feedback signal ($Y_{hi}$); generating, by a high-frequency primary distortion compensation processing module of the high-frequency primary DPD layer, a high-frequency primary predistorted signal ($U_{hi}$') based on the low-frequency secondary predistorted signal ($U_{lo}$) and the high-frequency secondary predistorted signal ($U_{hi}$) using the updated high-frequency primary signal generation coefficients; and combining, by a signal combining module, the low-frequency primary predistorted signal ($U_{lo}$') and the high-frequency primary predistorted signal ($U_{hi}$').

Also disclosed herein are embodiments of at least one non-transitory computer-readable medium storing instructions therein which, when run on a processor, causes the processor to carry out the method outlined above.

Further disclosed herein are transmitter systems, including the embodiment of the system described in this paragraph, each with a signal decomposition module configured to extract a low-frequency input signal ($S_{lo}$) and a high-frequency input signal ($S_{hi}$) from an input signal ($S_{in}$), a low-frequency intermodulation distortion filter module configured to filter a detected low-frequency feedback signal ($Y_{lo}$) to generate a targeted low-frequency filtered signal ($Y_{lo}$'), a high-frequency intermodulation distortion filter module configured to filter a detected high-frequency feedback signal ($Y_{hi}$) to generate a targeted high-frequency filtered signal ($Y_{hi}$'), a low-frequency primary DPD layer, a high-frequency primary DPD layer, a signal combining module, a low-frequency secondary DPD layer, and a high-frequency secondary DPD layer. The low-frequency primary DPD layer includes a low-frequency DPD coefficient estimation module configured to update low-frequency primary signal generation coefficients based on a low-frequency secondary predistorted signal ($U_{lo}$), a high-frequency secondary predistorted signal ($U_{hi}$), and the targeted low-frequency filtered signal ($Y_{lo}$'), and a

low-frequency primary distortion compensation processing module configured to generate a low-frequency primary predistorted signal ($U_{lo}$') based on the low-frequency secondary predistorted signal ($U_{lo}$) and a high-frequency secondary predistorted signal ($U_{hi}$) using the updated low-frequency primary signal generation coefficients. The high-frequency primary DPD layer includes a high-frequency DPD coefficient estimation module configured to update high-frequency primary signal generation coefficients based on the low-frequency secondary predistorted signal ($U_{lo}$), the high-frequency secondary predistorted signal ($U_{hi}$), and the targeted high-frequency filtered signal ($Y_{hi}$'), and a high-frequency primary distortion compensation processing module configured to generate a high-frequency primary predistorted signal ($U_{hi}$') based on the low-frequency secondary predistorted signal ($U_{lo}$) and the high-frequency secondary predistorted signal ($U_{hi}$) using the updated high-frequency primary signal generation coefficients. The signal combining module configured to combine the low-frequency primary predistorted signal ($U_{lo}$') and the high-frequency primary predistorted signal ($U_{hi}$'). The low-frequency secondary DPD layer includes a low-frequency signal characteristic estimation module configured to update low-frequency secondary signal generation coefficients based on the low-frequency input signal ($S_{lo}$), the high-frequency input signal ($S_{hi}$), and the targeted low-frequency filtered signal ($Y_{lo}$'), and a low-frequency secondary distortion compensation processing module configured to generate the low-frequency secondary predistorted signal ($U_{lo}$) based on the low-frequency input signal ($S_{lo}$) and the high-frequency input signal ($S_{hi}$) using the updated low-frequency secondary signal generation coefficients. The high-frequency secondary DPD layer includes a high-frequency signal characteristic estimation module configured to update high-frequency secondary signal generation coefficients based on the low-frequency input signal ($S_{lo}$), the high-frequency input signal ($S_{hi}$), and the targeted high-frequency filtered signal ($Y_{hi}$'), and a high-frequency secondary distortion compensation processing module configured to generate the high-frequency secondary predistorted signal ($U_{hi}$) based on the low-frequency input signal ($S_{lo}$) and the high-frequency input signal ($S_{hi}$) using the updated high-frequency secondary signal generation coefficients.

Further disclosed herein are methods for performing signal predistortion, including the embodiment of the method described in this paragraph, where each method includes extracting, by a signal decomposition module, a low-frequency input signal ($S_{lo}$) and a high-frequency input signal ($S_{hi}$) from an input signal ($S_{in}$); generating, by a low-frequency intermodulation distortion filter module, a targeted low-frequency filtered signal ($Y_{lo}$') by filtering a detected low-frequency feedback signal ($Y_{lo}$); generating, by a high-frequency intermodulation distortion filter module, a targeted high-frequency filtered signal ($Y_{hi}$') by filtering a detected high-frequency feedback signal ($Y_{hi}$); updating, by a low-frequency signal characteristic estimation module of a low-frequency secondary DPD layer, low-frequency secondary signal generation coefficients based on the low-frequency input signal ($S_{lo}$), the high-frequency input signal ($S_{hi}$), and the targeted low-frequency filtered signal ($Y_{lo}$'); generating, by a low-frequency secondary distortion compensation processing module of the low-frequency secondary DPD layer, a low-frequency secondary predistorted signal ($U_{lo}$) based on the low-frequency input signal ($S_{lo}$) and the high-frequency input signal ($S_{hi}$) using the updated low-frequency secondary signal generation coefficients; updating, by a high-frequency signal characteristic estimation module of a high-frequency secondary DPD layer, high-frequency secondary signal generation coefficients based on the low-frequency input signal ($S_{lo}$), the high-frequency input signal ($S_{hi}$), and the targeted high-frequency filtered signal ($Y_{hi}$'); generating, by a high-frequency secondary distortion compensation processing module of the high-frequency secondary DPD layer, a high-frequency secondary predistorted signal ($U_{hi}$) based on the low-frequency input signal ($S_{lo}$) and the high-frequency input signal ($S_{hi}$) using the updated high-frequency secondary signal generation coefficients; updating, by a low-frequency DPD coefficient estimation module of a low-frequency primary DPD layer, low-frequency primary signal generation coefficients based on the low-frequency secondary predistorted signal ($U_{lo}$), the high-frequency secondary predistorted signal ($U_{hi}$), and the targeted low-frequency filtered signal ($Y_{lo}$'); generating, by a low-frequency primary distortion compensation processing module of the low-frequency primary DPD layer, a low-frequency primary predistorted signal ($U_{lo}$') based on the low-frequency secondary predistorted signal ($U_{lo}$) and the high-frequency secondary predistorted signal ($U_{hi}$) using the updated low-frequency primary signal generation coefficients; updating, by a high-frequency DPD coefficient estimation module of a high-frequency primary DPD layer, high-frequency primary signal generation coefficients based on the low-frequency secondary predistorted signal ($U_{lo}$), the high-frequency secondary predistorted signal ($U_{hi}$), and the targeted high-frequency filtered signal ($Y_{hi}$'); generating, by a high-frequency primary distortion compensation processing module of the high-frequency primary DPD layer, a high-frequency primary predistorted signal ($U_{hi}$') based on the low-frequency secondary predistorted signal ($U_{lo}$) and the high-frequency secondary predistorted signal ($U_{hi}$) using the updated high-frequency primary signal generation coefficients; and combining, by a signal combining module, the low-frequency primary predistorted signal ($U_{lo}$') and the high-frequency primary predistorted signal ($U_{hi}$').

Further disclosed herein are embodiments of at least one non-transitory computer-readable medium storing instructions therein which, when run on a processor, causes the processor to carry out the method outlined above.

While multiple embodiments are disclosed, still other embodiments of the present disclosure will become apparent to those skilled in the art from the following detailed description, which shows and describes illustrative embodiments of the disclosure. Accordingly, the drawings and detailed description are to be regarded as illustrative in nature and not restrictive.

Brief description of the drawings

The embodiments will be more readily understood in view of the following description when accompanied by the below figures and wherein like reference numerals represent like elements. These depicted embodiments are to be understood as illustrative of the disclosure and not as limiting in any way.

Fig. 1 shows a prior-art signal transmission system including a known distortion compensation device.

Fig. 2 shows a signal transmission system with dual-layer distortion compensation, according to the embodiments disclosed herein.

Fig. 3A shows a signal transmission system with dual-layer distortion compensation and distortion compensation functionality having a targeted spectrum emission, according to the embodiments disclosed herein.

Fig. 3B shows exemplary subcomponents of a filter module of the signal transmission system of Fig. 3A according to the embodiments disclosed herein.

Fig. 4A shows a signal transmission system with dual-layer and dual-band distortion compensation, according to the embodiments disclosed herein.

Fig. 4B shows the individual components of the signal transmission system with dual-layer and dual-band distortion compensation of Fig. 4A, according to the embodiments disclosed herein.

Fig. 5 shows a signal transmission system with dual-layer and dual-band distortion compensation as well as distortion compensation functionality having a targeted spectrum emission, according to the embodiments disclosed herein.

Fig. 6 shows a signal transmission device with distortion compensation functionality, according to the embodiments disclosed herein.

FIGs. 7A and 7B show processes of performing signal transmission with dual-layer distortion compensation, according to the embodiments disclosed herein.

Fig. 8 shows a process of performing signal transmission with dual-layer distortion compensation and distortion compensation functionality having a targeted spectrum emission, according to the embodiments disclosed herein.

Fig. 9 shows a process of performing dual-band signal transmission with dual-layer distortion compensation, according to the embodiments disclosed herein.

Fig. 10 shows a process of performing dual-band signal transmission with dual-layer distortion compensation and distortion compensation functionality having targeted spectrum emission, according to the embodiments disclosed herein.

Fig. 11 shows an exemplary gain mask for preprocessing feedback data, according to the embodiments disclosed herein.

Fig. 12 shows an exemplary filtering result for FCC spectrum emission spec in 5G NR100 signal, according to the embodiments disclosed herein.

While the present disclosure is amenable to various modifications and alternative forms, specific embodiments have been shown by way of example in the drawings and are described in detail below. The intention, however, is not to limit the present disclosure to the particular embodiments described. On the contrary, the present disclosure is intended to cover all modifications, equivalents, and alternatives falling within the scope of the present disclosure as defined by the appended claims.

Detailed description of the disclosure

In the following detailed description, reference is made to the accompanying drawings which form a part hereof, and in which is shown by way of illustration specific embodiments in which the present disclosure is practiced. These embodiments are described in sufficient detail to enable those skilled in the art to practice the present disclosure, and it is to be understood that other embodiments can be utilized and that structural changes can be made without departing from the scope of the present disclosure. Therefore, the following detailed description is not to be taken in a limiting sense, and the scope of the present disclosure is defined by the appended claims and their equivalents.

Reference throughout this specification to "one embodiment," "an embodiment," or similar language means that a particular feature, structure, or characteristic described in connection with the embodiment is included in at least one embodiment of the present disclosure. Appearances of the phrases "in one embodiment," "in an embodiment," and similar language throughout this specification may, but do not necessarily, all refer to the same embodiment. Similarly, the use of the term "implementation" means an implementation having a particular feature, structure, or characteristic described in connection with one or more embodiments of the present disclosure, however, absent an express correlation to indicate otherwise, an implementation may be associated with one or more embodiments. Furthermore, the described features, structures, or characteristics of the subject matter described herein may be combined in any suitable manner in one or more embodiments.

With respect to terminology, the terms "about" and "approximately" may be used, interchangeably, to refer to a measurement that includes the stated measurement and that also includes any measurements that are reasonably close to the stated measurement. Measurements that are reasonably close to the stated measurement deviate from the stated measurement by a reasonably small amount as understood and readily ascertained by individuals having ordinary skill in the relevant arts. Such deviations may be attributable to measurement error, differences in measurement and/or manufacturing equipment calibration, human error in reading and/or setting measurements, minor adjustments made to optimize performance and/or structural parameters in view of differences in measurements associated with other components, particular implementation scenarios, imprecise adjustment and/or manipulation of objects by a person or machine, and/or the like, for example. In the event it is determined that individuals having ordinary skill in the relevant arts would not readily ascertain values for such reasonably small differences, the terms "about" and "approximately" can be understood to mean plus or minus 10% of the stated value.

## Implementation 1

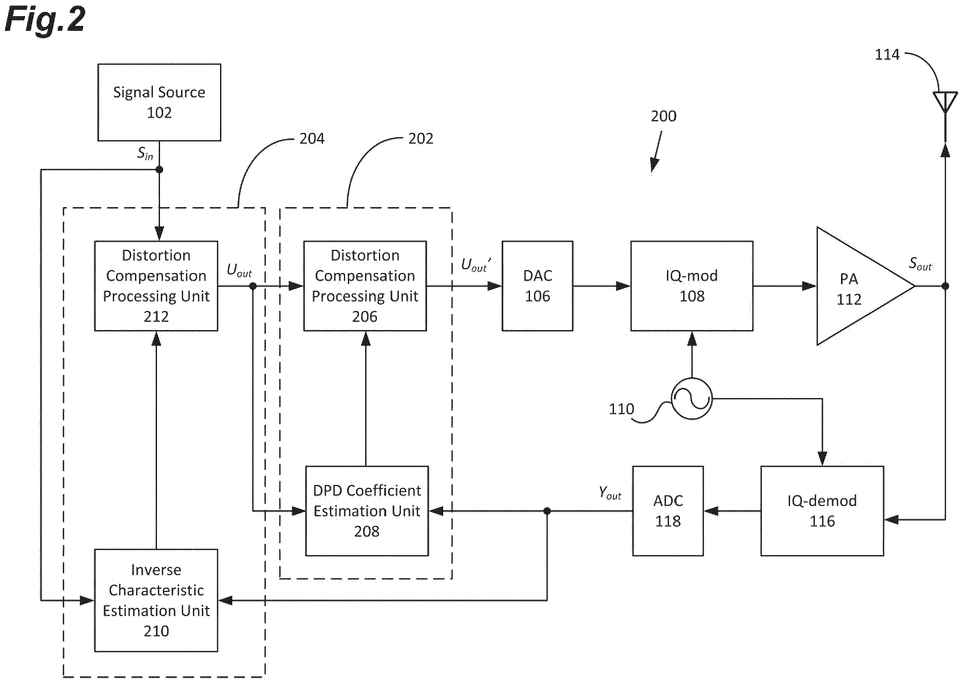

Fig. 2 illustrates an example of a signal transmission device or system 200 as disclosed herein for performing digital predistortion (DPD) for distortion compensation of the PA 112. It is to be understood that in some examples, each of the functional blocks in the figures may be implemented as an individual component, or a plurality of functional blocks may be implemented together in a component, as suitable for designing, manufacturing, or operating the device or system. The system 200 includes a primary DPD layer 202 and a secondary DPD layer 204 for performing distortion compensation, where the output signal ($U_{out}$') from the primary layer 202 incorporates the predistortion applied to the input signal ($S_{in}$) before the output signal is fed to the DAC 106, the IQ modulator 108, and then to the PA 112 to be transmitted as an output signal ($S_{out}$). The secondary layer 204 assists the primary layer 202 by providing another layer of distortion compensation such that the secondary output signal ($U_{out}$) from the secondary layer 204 is fed to the primary layer 202 which then further applies distortion compensation to the signal ($U_{out}$) to generate the primary output signal ($U_{out}$') which is distortion compensated. In other words, the output signal ($U_{out}$) corresponds to the input signal ($S_{in}$) as predistorted by the secondary DPD layer 204 and the output signal ($U_{out}$') corresponds to the output signal ($U_{out}$) as predistorted by the primary DPD layer 202.

In some examples, the primary layer 202 includes a distortion compensation processing unit 206 and a DPD coefficient estimation unit 208, and the secondary layer 204 includes a distortion compensation processing unit 212 and an inverse characteristic estimation unit, also referred to as a signal characteristic estimation module, 210. The output signal ($S_{out}$) is provided via a feedback loop to an IQ signal demodulator 116, using the same frequency of the local oscillator 110 as the IQ modulator 108, which may be a frequency of 2140 MHz, for example, and the demodulated signal is provided to the analog-digital converter (ADC) 118. The output from the ADC 118 is fed to both the DPD coefficient estimation unit 208 and the signal characteristic estimation module 210, after which each of the estimation units 208 and 210 provides updated primary and secondary signal generation coefficients for the distortion compensation processing units 206 and 212, respectively. The secondary coefficients are applied to a polynomial model as known in the art to generate the secondary predistorted output signal ($U_{out}$) from the distortion compensation processing unit 212, and the primary coefficients are applied to a polynomial model as known in the art to generate the primary predistorted output signal ($U_{out}$') from the distortion compensation processing unit 206.

Discussed below is an exemplary implementation of the subject disclosure according to some embodiments as disclosed herein. Based on a generalized polynomial model indicated in Lei et al, "A Robust Digital Baseband Predistorter Constructed Using Memory Polynomials," IEEE Transactions on Communications, 52(1), p.159-165, in some examples, the predistorted output signal may be generated using the following form:

$$y(n) = \sum_{l=0}^{L-1} x(n-l) \sum_{m=-M_1}^{M_2} b_{lm} \sum_{k=0}^{K} a_{mk} |x(n-l-m)|^{2k}$$

(Equation 1)

where L is the memory depth, K is the highest nonlinearity order, $M_1$ is backward cross term length, $M_2$ is forward cross term length, and $a_{mk}$ and $b_{lm}$ are the signal generation coefficients which are updated according to compensate for the distortion caused by the PA. Thus, for example, in the system depicted in Fig. 2, y(n) and x(n) may correspond to $U_{out}$' and $U_{out}$, respectively, when implemented by the primary DPD layer 202, or to $U_{out}$ and $S_{in}$, respectively, when implemented by the secondary DPD layer 204. The coefficients may be collected or provided in a matrix or a table stored in the memory, which is utilized by a processor for calculating the predistorted signal using the above equation as will be described below.

Specifically, the DPD coefficient estimation module 208 updates primary signal generation coefficients based on comparing a secondary predistorted signal ($U_{out}$) with a detected feedback signal ($Y_{out}$). The primary distortion compensation processing module 206 generates a primary predistorted signal ($U_{out}$') based on the secondary predistorted signal ($U_{out}$) using the updated primary signal generation coefficients. The signal characteristic estimation module 210 updates secondary signal generation coefficients based on comparing an input signal ($S_{in}$) with the detected feedback signal ($Y_{out}$). The secondary distortion compensation processing module 212 generates the secondary predistorted signal ($U_{out}$) based on the input signal ($S_{in}$) using the updated secondary signal generation coefficients. Each DPD layer, therefore, is responsible for updating a separate set of coefficients (primary or secondary). In the feedback loop comprising the IQ demodulator 116, ADC 118, and the DPD coefficient estimation unit 208, the output signal $S_{out}$ is demodulated using the IQ demodulator 116 using the same frequency supplied to the IQ modulator 108. The detected digital feedback signal $Y_{out}$ is generated by passing the demodulated signal through the ADC 118.

In some examples, the primary DPD layer 202 updates the primary signal generation coefficients by performing direct or indirect learning, while the secondary DPD layer 204 updates the secondary signal generation coefficients by performing direct learning. For example, a direct learning algorithm calculates the coefficients by inversing a channel transfer function, and an indirect learning algorithm calculates the coefficients using an adaptive algorithm driven by error signals. Examples of these algorithms are described in detail below.

More specifically, the direct learning involves receiving the output signal ($S_{out}$) from the PA 112 as a reference to compare with the input signal ($S_{in}$) as originally provided, and a learning model such as inverse modeling is implemented to calculate the coefficients for the nonlinear terms of the polynomial model. The indirect learning involves receiving an error signal which results from comparing the input and output signals (that is, $S_{in}$ and $S_{out}$), after which the error signal is decomposed into nonlinear terms. The coefficients are calculated to reconstruct the error signal using the polynomial model, after which the nonlinear terms of the error signal are subtracted from the received signal to generate the predistorted signal.

In some examples, both the primary DPD layer 202 and the secondary DPD layer 204 perform the direct learning, whereas in some examples, only the secondary DPD layer performs the direct learning while the primary DPD layer performs the indirect learning based on the error signal. Different methods of direct and indirect learning may be implemented as known in the art.

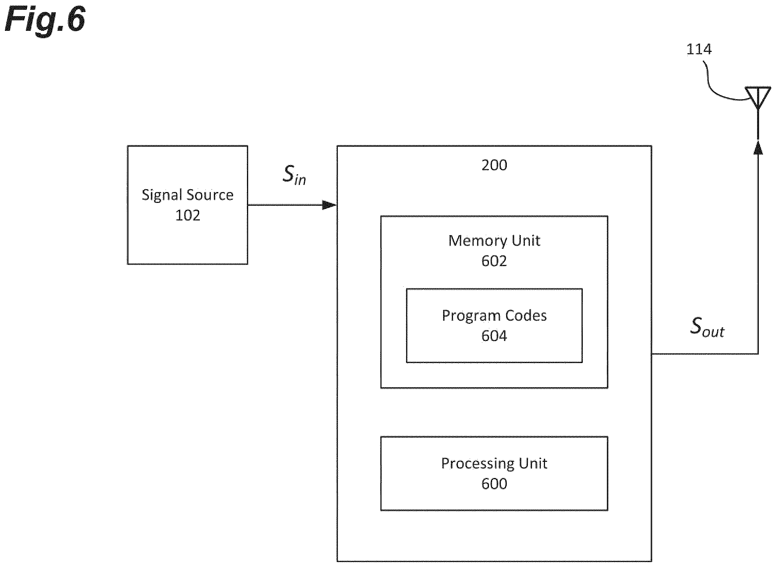

Fig. 6 shows the block diagram of an example of the signal transmission system 200 according to embodiments disclosed herein. Each of the individual blocks or modules as explained with respect to the signal transmission system 200 may be implemented as at least one processing unit 600 coupled with a memory unit 602 which stores thereon program codes 604 to be executed by the processing unit or processor 600. In some examples, each block or module may be implemented using a single processor or a set of processor operating together. In some examples, multiple blocks or modules may be implemented using a single processor or a set of processors operating together. The processing unit or processor may be any suitable device for processing data inputs, including but not limited to a central processing unit (CPU) of a computing device, a virtual CPU of a virtual machine, a multicore CPU, a system on a chip (SoC), etc., which have been specifically programmed or instructed as described herein to carry out the specific operations of the present disclosure. The processing unit or processor may be a programmable processing or micro-processing device of a solid-state, integrated circuit type that includes one or more processing units and memory. Processors can include one or more Arithmetic Logic Units (ALUs), CPUs, memory devices, and/or different circuitry or functional components, etc., as would occur to those skilled in the art to perform the desired implementations. The processing unit or processor may be communicatively coupled with an external device such as a user device (including but not limited to desktop or laptop computer, smartphone, personal digital assistant, tablet computer, etc.) via any suitable device for digital communications including but not limited to the Internet, a cloud computing network, or a personal area network such as WLAN/WPAN connectivity, either via wired or wireless communications. In some examples, there may be a plurality of processors which are functionally coupled together and therefore operate together.

The memory unit 602 may be any suitable non-transitory computer-readable storage medium which can be local, remote, or distributed. The memory may include, among others, random access memory (RAM), such as dynamic RAM (DRAM) and static RAM (SRAM), for example. The memory may also be a non-volatile storage such as a magnetic floppy or hard disk, a magnetic-optical disk, an optical disk, a read-only memory (ROM), such as a CD-ROM, EPROM, or EEPROM, a magnetic or optical card, or another form of storage for large amounts of data. Some of this data is often written, by a direct memory access process, into memory during execution of software on the computer system. The memory may also store the software or computer program codes 604 which, when executed by the processor 600, perform the methods, processes, and/or algorithms as disclosed herein.

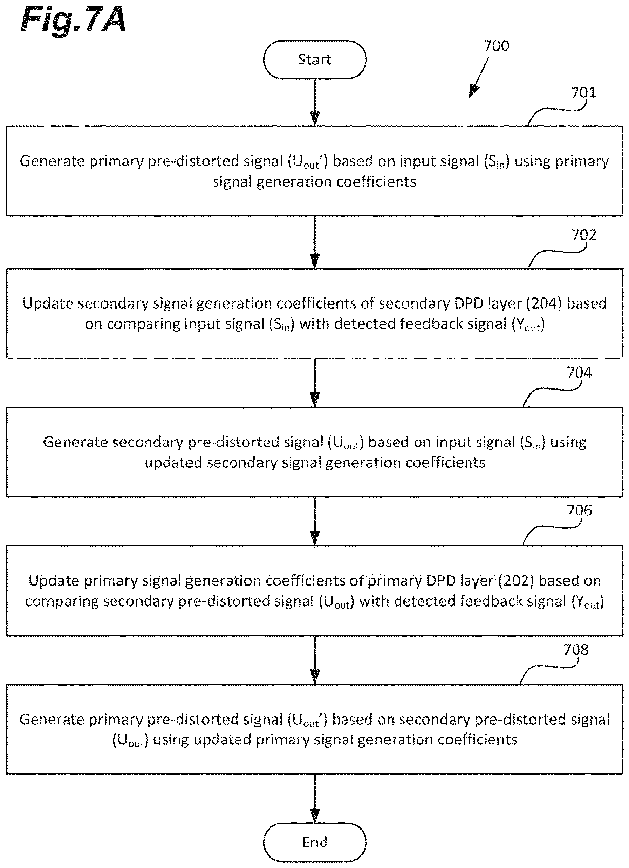

FIGs. 7A shows an example of a process 700 performed by the processor 600 according to embodiments disclosed herein. The process 700 may be performed by the processor 600 when the instructions or program codes 604 stored on the non-transitory computer-readable medium or the memory unit 602 are run on the processor 600. In the process 700, the processor implements a passthrough mode in the secondary DPD layer in step 701, which causes the secondary DPD layer to output the input signal ($S_{in}$) without any distortion compensation applied to the signal, thereby providing the input signal ($S_{in}$) to the primary DPD layer, and the primary DPD layer generates the primary predistorted signal ($U_{out}'$) based on the input signal ($S_{in}$) using the primary signal generation coefficients. In some examples, the secondary DPD layer implements the passthrough mode during the initial iteration(s) of signal transmission, such that the feedback signal can be properly analyzed to calculate the appropriate coefficients. In some examples, as further explained herein, the passthrough mode is implemented when the distortion of the input signal is below a threshold such that it is not necessary for the secondary DPD layer to provide the additional predistortion as further disclosed herein.

The processor updates the secondary signal generation coefficients of the secondary DPD layer based on comparing the input signal ($S_{in}$) with the detected feedback signal ($Y_{out}$) from the amplifier, in step 702. The processor in step 704 generates the secondary predistorted signal ($U_{out}$) based on the input signal ($S_{in}$) using the updated secondary signal generation coefficients. In step 706, the processor updates the primary signal generation coefficients of the primary DPD layer based on comparing the secondary predistorted signal ($U_{out}$) with the detected feedback signal ($Y_{out}$). In step 708, the processor generates the primary predistorted signal ($U_{out}'$) based on the secondary predistorted signal ($U_{out}$) using the updated primary signal generation coefficients.

The primary DPD layer may update the corresponding coefficients using direct or indirect learning algorithm, whereas the secondary DPD layer may update the corresponding coefficients using the direct learning algorithm. In some examples, the direct learning algorithm includes performing inverse modeling for inversing a channel transfer function.

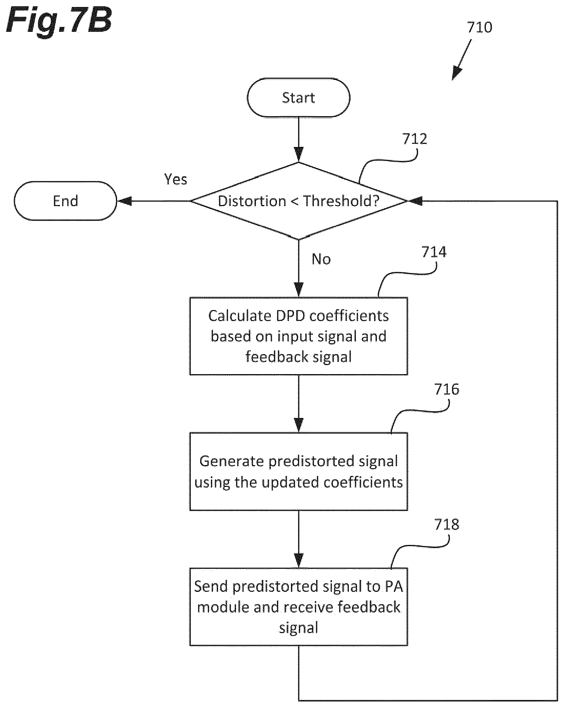

Fig. 7B shows an example of a generalized process 710 performed by the processor 600 according to embodiments disclosed herein, where the process 710 determines whether or not to activate DPD correction process, that is, the process 700 in Fig. 7A. The process 710 may be performed for each of the primary and secondary DPD layers. In step 712, the processor determines whether the level of detected signal distortion, which may be determined by analyzing the difference between the input and output signals, for example, exceeds a predetermined threshold value. The threshold value may indicate the maximum amount of distortion that is acceptable for the transmission, which may be preset or dictated in Third Generation Partnership Project (3GPP) systems and systems that may employ one or more aspects of the specifications of the Third Generation (3G), Fourth Generation (4G), Fifth Generation (5G), or any subsequent generation standard for wireless communications as would be familiar with those skilled in the art.

The process 710 ends without activating the DPD correction process if the distortion level is below threshold. In some examples, this indicates that the secondary DPD layer may remain in the passthrough mode such that no predistortion needs to be applied by the secondary DPD layer. In such cases, the primary DPD layer alone may be capable of providing the necessary predistortion to the input signal to maintain a below-threshold level of distortion in the signal. Otherwise, the process 710 proceeds to step 714, where the processor calculates the DPD coefficients based on the input signal and the feedback signal ($Y_{out}$) obtained from the feedback loop. In step 716, the processor generates a predistorted signal using the updated coefficients. In step 718, the processor sends the predistorted signal to the PA module and receives the feedback signal to determine if the level of signal distortion caused by the PA module is still greater than the threshold value, as per step 712.

If the DPD layer in question is the primary DPD layer, the "input signal" from step 714 may be either the original input signal ($S_{in}$) or the output signal from the secondary DPD layer ($U_{out}$), and the "predistorted signal" generated in step 716 may be the primary output signal ($U_{out}'$) that is fed to the PA 112. If the DPD layer in question is the secondary DPD layer, the "input signal" may be the original input signal ($S_{in}$), and the generated "predistorted signal" may be the secondary output signal ($U_{out}$) that is fed to the primary DPD layer. Furthermore, the "PA module" from step 718 may refer to the PA 112 when the DPD layer in question is the primary DPD layer, or it may refer to the combination of the distortion compensation processing unit 206 and the PA 112 when the DPD layer in question is the secondary DPD layer.

Advantages of implementing the signal transmission device or system as disclosed herein include the ability for the system to increase the accuracy of the predistortion being applied to the input signal by implementing a two-layer distortion compensation. The two-layer distortion compensation may be beneficial in applying two different learning algorithms, that is, direct and indirect, such that the distortion compensation not only reduces the difference between input and output signals via direct learning, but also takes into consideration the error signal and subtracts its components from the input signal as part of the predistortion, via indirect learning.

### Implementation 2

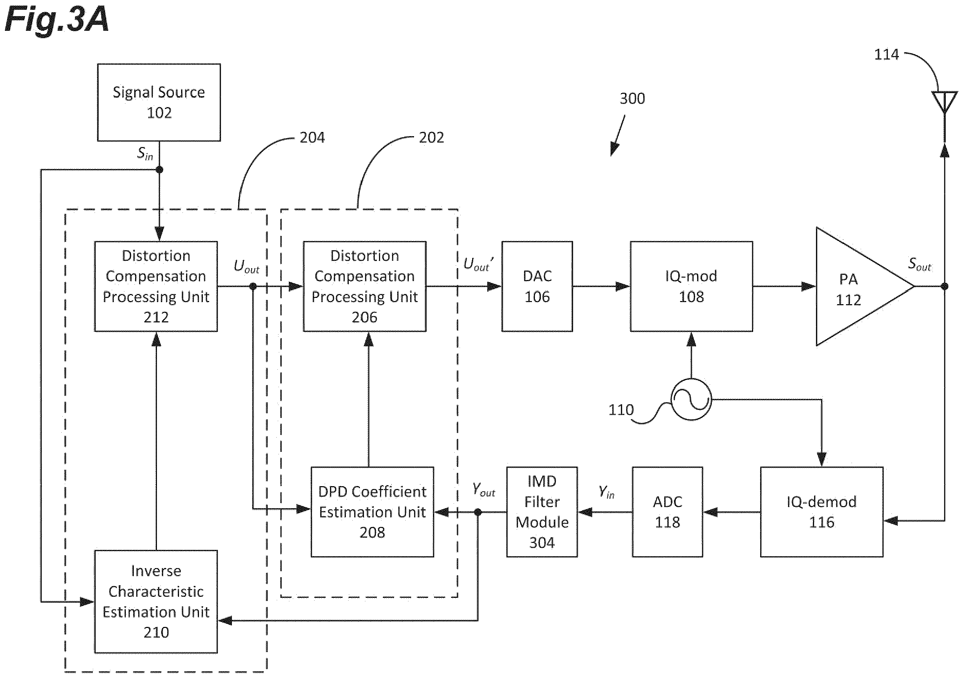

Fig. 3A illustrates an example of a signal transmission device or system 300 as disclosed herein. It is to be understood that in some examples, each of the functional blocks in the figures may be implemented as an individual component, or a plurality of functional blocks may be implemented together in a component, as suitable for designing, manufacturing, or operating the device or system. The system 300 includes, in addition to the primary DPD layer 202 and the secondary DPD layer 204, an intermodulation distortion (IMD) filter module 304 in the feedback loop.

The feedback output signal ($S_{out}$) is passed through the IQ demodulator 116 to generate the demodulated signal, and the demodulated signal is passed through the ADC 118 to generate the input signal ($Y_{in}$) for the IMD filter module 304, the output of which is a gain-compensated output signal ($Y_{out}$). The gain-compensated output signal ($Y_{out}$) is then provided to both the primary DPD layer 202 and the secondary DPD layer 204 for predistortion analysis (as shown in Fig. 7A or 7B, for example). The IMD filter 304 operates to filter the IMD or spectrum emission of the input signal such that only the desired portion of the IMD or spectrum emission is retained, while the other portions are left out or eliminated in order to reduce the adjacent channel power ratio (ACPR). A high ACPR indicates that significant spectral spreading has occurred; therefore it is preferable that the ACPR be kept as low as possible. Typically, third-order intermodulation products (that is, third-order IMD) are the result of nonlinear behavior of an amplifier; as such, it is desired to correct the third-order IMD without, for example, affecting another nearby emission.

In some examples, an IMD filter is applied to lower the spectral density of a spectrum emission at portions other than the desired ranges of frequency. For example, the transmitted signal has two component carriers with wideband spacing, and the desired frequency ranges are determined based on the frequencies of the component carriers. In some examples, the difference between the ranges may be at least approximately 10 MHz, at least approximately 20 MHz, at least approximately 30 MHz, at least approximately 40 MHz, at least approximately 50 MHz, at least approximately 100 MHz, or any other suitable value or range therebetween. In some examples, the ranges themselves may span at least approximately 10 MHz, at least approximately 20 MHz, at least approximately 30 MHz, at least approximately 40 MHz, at least approximately 50 MHz, at least approximately 100 MHz, or any other suitable value or range therebetween.

As the number of iterations of DPD increases, at a later stage of DPD iteration, the undesired portions of the signals are filtered out, leaving only the desired frequency components. In the filtered signal after a number of DPD iterations, the peak spectral densities located between the desired frequency ranges is reduced, and the spectral density of the spectrum within the desired frequency ranges are increased, as appropriate.

The output signal $Y_{out}$ from the IMD filter module 304 is provided to the DPD coefficient estimation unit 208 of the primary DPD layer 202 to update the primary coefficients for distortion compensation, and also to the signal characteristic estimation module 210 of the secondary DPD layer 204 to update the secondary coefficients for distortion compensation. The primary coefficient estimation may be performed by the DPD coefficient estimation unit 208 via direct or indirect learning, for example, and the secondary coefficient estimation may be performed by the signal characteristic estimation module 210 via direct learning, for example. The secondary coefficients are then applied to a polynomial model as known in the art to generate the secondary predistorted output signal ($U_{out}$), and the primary coefficients are applied to a polynomial model as known in the art to generate the primary predistorted output signal ($U_{out}'$).

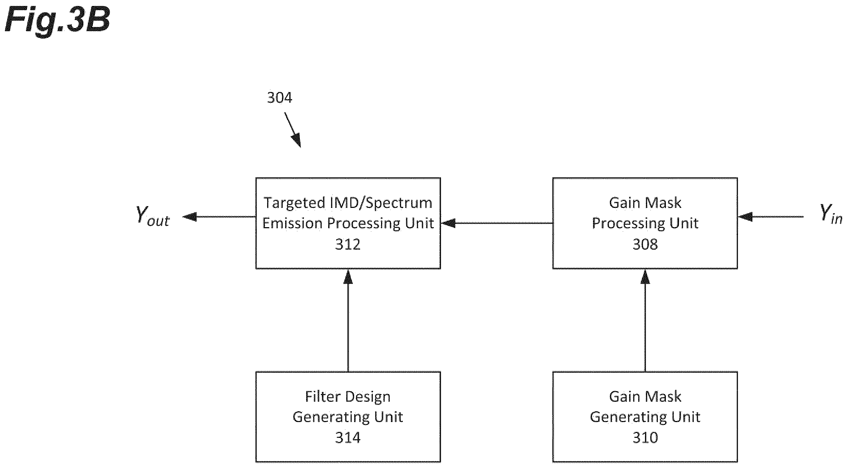

Fig. 3B shows the exemplary subcomponents of the IMD filter module 304 according to some embodiments. The module 304 includes four components: a gain mask processing unit 308, a gain mask generating unit 310, a targeted IMD/spectrum emission processing unit 312, and a filter design generating unit 314. Each of these components may be implemented using a separate processing unit, or alternatively, two or more of the components may be implemented using the same processing unit.

The gain mask generating unit 310 generates a gain mask which is to be applied to the input of the IMD filter module 304, i.e. the input feedback signal $Y_{in}$. The configuration of the gain mask may be determined by measurements such as the gain response of the PA 112 in specific frequency ranges. The gain response of the PA 112 may be measured using any suitable standard network analyzer as known in the art, for example, which compares the input and the output of the PA 112 to determine its state of gain-over-frequency as well as its phase. The standard network analyzer may be implemented as separate equipment from the gain mask generation unit 310 and is functionally coupled with the PA 112 to take the aforementioned measurements, as suitable. The measurements pertaining to the PA gain response may be then transmitted to the gain mask generation unit 310 for suitable gain mask generation.

Typically, the PA 112 meets the gain specification within the predetermined transmission band, but the gain can drop rapidly once outside the transmission band. The DPD may typically require a multiple of the carrier bandwidth (for example, five times the carrier bandwidth), in which case it is desirable for the gain slope of the frequency portion that is outside the transmission band to be compensated by the gain mask processing unit 308. Specifically, the gain mask processing unit 308 may receive the gain mask generated by the gain mask generating unit 310 using the aforementioned process, then perform gain compensation on the received input feedback signal $Y_{in}$ (for example, from the ADC 118) based on the gain mask. In some examples, the resulting gain-compensated signal may then be sent to the targeted IMD/spectrum emission processing unit 312 which filters out all but the desired frequency components. Such filtering may occur in the later stage of DPD iterations. The filter used by the targeted IMD/spectrum emission processing unit 312 is generated by the filter design generating unit 314 which may generate the filter based on one or more requirements and other factors. For example, the requirement may involve predetermined threshold frequencies or frequency ranges as determined by the 3GPP systems and systems that may employ one or more aspects of the specifications of the 3G, 4G, 5G, or any subsequent generation standard for wireless communications as would be familiar with those skilled in the art.

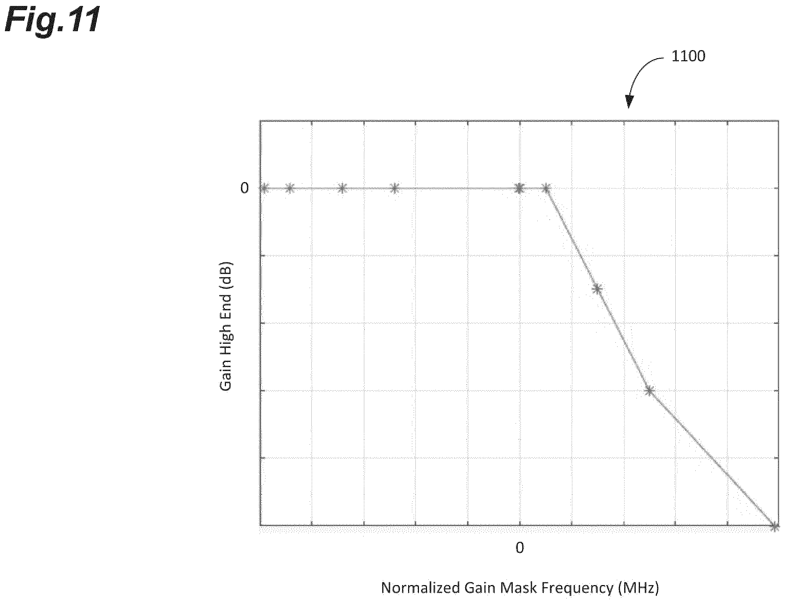

Fig. 11 shows an exemplary normalized gain mask 1100 for preprocessing feedback data signal $Y_{in}$ according to some implementations. According to various implementations, the high end of the gain mask 1100 may be centered around any suitable threshold frequency (for example, between approximately 1800 MHz and 4 GHz, etc., or any other frequency range or value therebetween) as determined by the system, based on the required masking that is to be implemented in view of measurements such as the PA gain response, for example. In the gain mask, the gain high end is at a determined threshold frequency, which indicates the gain is unaltered until at least the threshold frequency is reached, beyond which the gain decreases to negative decibels as shown. The decline slope of the gain decrease beyond the central frequency may be determined according to the measurements taken at, for example approximately -1 dB, approximately -2 dB, approximately -3 dB, approximately -4 dB, approximately -5 dB, or any other suitable value therebetween, for every 100 MHz. In some examples, the specific value of the high end frequency may be chosen from: 1880 MHz, 2170 MHz, 3800 MHz, or 3980 MHz.

It should be understood that another gain slope may exist at a low end of the gain mask, only reversed in the opposite direction from the high end as shown in Fig. 11. For example, the gain low end may be centered around any suitable threshold frequency (for example, between approximately 1800 MHz and 4 GHz, etc., or any other frequency range or value therebetween) that is lower than the threshold frequency of the gain high end. As the frequency increases, the gain reduction decreases until it reaches 0 dB, and beyond the threshold frequency, the gain remains unaltered at 0 dB. The incline slope of the gain until the frequency reaches the threshold frequency may be determined according to the measurements taken at, for example approximately 1 dB, approximately 2 dB, approximately 3 dB, approximately 4 dB, approximately 5 dB, or any other suitable value therebetween, for every 100 MHz. In some examples, the specific value of the low end frequency may be chosen from: 1805 MHz, 2110 MHz, 3400 MHz, or 3700 MHz.

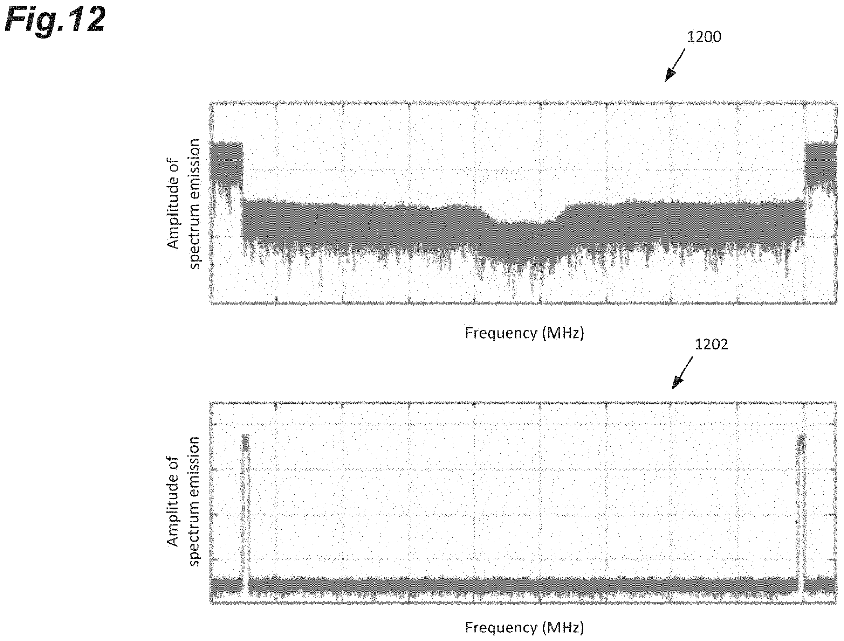

Fig. 12 shows a resulting signal 1202 after applying an exemplary filter as generated by the filter design generating unit 314 to a feedback signal 1200 from the amplifier, according to some implementations. The wireless communication may be subject to be compliant with any one of the standards with different requirements, such as the Federal Communications Commission (FCC) and the Institute of Electrical and Electronics Engineers (IEEE), to name a few. Particularly, the filter designed to meet compliance requirements for the FCC spectrum emission specification for the 5G New Radio (NR) standard signal, for example, such that the close-in spectrum emission can be corrected. The filter is configured to remove all frequency components except for the desired frequency locations, resulting in the signal with filtered spectrum emission, as shown in 1202. The bandwidth surrounding each of the peak-amplitude frequencies in the filtered signal may be any suitable value, for example approximately 5 MHz, 10 MHz, 15 MHz, 20 MHz, or any other suitable value or range therebetween.

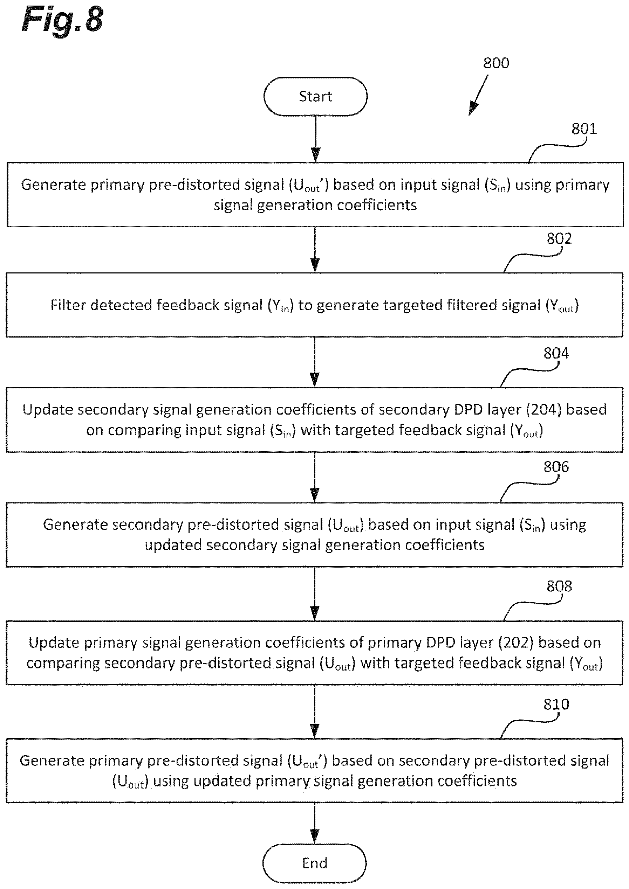

Fig. 8 shows an example of a process 800 performed by the processor 600 according to embodiments disclosed herein. The process 800 may be performed by the processor 600 when the instructions or program codes 604 stored on the non-transitory computer-readable medium or the memory unit 602 are run on the processor 600. The process 800 includes the processor implements the passthrough mode in the secondary DPD layer in step 801, which causes the secondary DPD layer to output the input signal ($S_{in}$) without any distortion compensation applied to the signal, thereby providing the input signal ($S_{in}$) to the primary DPD layer, and the primary DPD layer generates the primary predistorted signal ($U_{out}'$) based on the input signal ($S_{in}$) using the primary signal generation coefficients. The process 800 also includes the processor filtering the detected feedback signal ($Y_{in}$) to generate a targeted filtered signal ($Y_{out}$) in step 802. The processor then updates the secondary signal generation coefficients based on the comparison between the input signal ($S_{in}$) and the targeted filtered signal ($Y_{out}$) in step 804. Then, the processor generates the secondary predistorted signal ($U_{out}$) based on the input signal ($S_{in}$) using the updated secondary signal generation coefficients in step 806. In step 808, the processor updates the primary signal generation coefficients based on the comparison between the secondary predistorted signal ($U_{out}$) and the targeted filtered signal ($Y_{out}$). Then, the processor generates the primary predistorted signal ($U_{out}'$) based on the secondary predistorted signal ($U_{out}$) using the updated primary signal generation coefficients in step 810. The primary predistorted signal ($U_{out}'$) is then provided to the PA to be transmitted.

Step 802 may be performed by the IMD filter module 304 of the processor. Step 804 may be performed by the signal characteristic estimation module 210 of the processor, and step 806 may be performed by the distortion compensation processing module 212 of the processor, both of which are components of the secondary DPD layer 204. Step 808 may be performed by the DPD coefficient estimation unit 208 of the processor, and step 806 may be performed by the distortion compensation processing module 206 of the processor, both of which are components of the primary DPD layer 202. Alternatively, these modules may be implemented as a single device or component or as any other suitable number of components.

In some examples, the process 800 further involves using the processor, or in some examples the gain mask generating module 310 of the IMD filter module 304, to generate a gain mask based on at least one transmission measurement. The process 800 may also involve using the processor, in some examples the gain mask processing module 308 of the IMD filter module 304, to apply the gain mask to the detected feedback signal ($Y_{in}$). Subsequently, the processor, or in some examples the filter design generation module 314 of the IMD filter module 304, generates a signal filter based on at least one transmission requirement. Then, the processor, or in some examples the targeted filtered signal generating module 312 of the IMD filter module 304, generates the targeted filtered signal ($Y_{out}$) based on the generated signal filter.

In some examples, the gain mask is generated during the process 800 based on at least one measurement of a gain response of an amplifier of the transmitter system in a frequency range. In some examples, transmission requirement are determined based on or according to the standards requirements for the Long-Term Evolution (LTE), 3G, 4G, or 5G New Radio (NR) specifications, among others. In some examples, the standards requirement of any other suitable radio access technology for a telecommunication network are as known in the art.

In some examples, the process 800 includes causing the processor, or in some examples the gain mask processing module 308, to generate a gain compensated signal, and the processor, or in some examples the targeted filtered signal generating module 312, generates the targeted filtered signal ($Y_{out}$) by applying the signal filter on the gain compensated signal. In some examples, the processor, or in some examples the targeted filtered signal generating module 312, generates the targeted filtered signal ($Y_{out}$) by reducing gain of the gain compensated signal except at desired frequency components of the gain compensated signal. The desired frequency components may be determined based on the transmission requirement, such as those of the standards requirement for any suitable radio access technology specification.

Advantages of implementing the signal transmission device or system as disclosed herein include the ability for the system to incorporate additional adjustments to the feedback signal (that is, $Y_{in}$) to provide the gain compensation before using the gain-compensated feedback signal (that is, $Y_{out}$) to update the signal generation coefficients for generating the predistorted signal (that is, $U_{out}$) to be used for transmission. The adjustments enabled by the gain mask and the signal filter may be implemented for different purposes. For example, the gain mask is used to compensate for the distortions caused by the PA gain response, and the signal filter is used to meet the transmission requirements as determined by the 3GPP, such as LTE, 3G, 4G, 5G, etc. Furthermore, the additional adjustments further improve the accuracy of the updated coefficients based on which the next predistorted signal is generated, such that there is less distortion in the final transmitted signal (that is, $S_{out}$).

Implementation 3

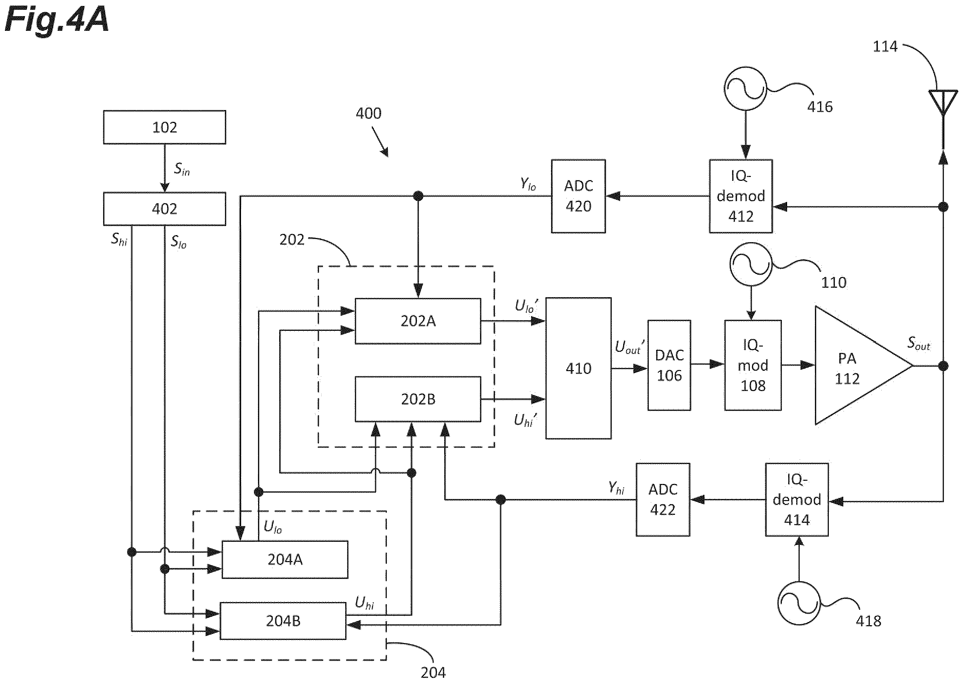

Fig. 4A illustrates an example of a signal transmission device or system 400 as disclosed herein. It is to be understood that in some examples, each of the functional blocks in the figures may be implemented as an individual component, or a plurality of functional blocks may be implemented together in a component, as suitable for designing, manufacturing, or operating the device or system. The system 400 includes a signal decomposition module 402 which extracts a low-frequency signal ($S_{lo}$) and a high-frequency signal ($S_{hi}$) from an input signal ($S_{in}$) provided from the signal source 102. The signal extraction is based on extracting only a portion of the input signal, where the portion of the signal to be extracted is determined based on two different and separate carrier frequencies. Any suitable method of signal extraction may be implemented, including but not limited to linear filtering. For example, the carrier frequency for each of the low-frequency and high-frequency extractions may be determined based on the spectral density of the input signal, as further discussed herein. Examples of frequencies for the low-frequency signal ($S_{lo}$) and a high-frequency signal ($S_{hi}$) may be 1840 MHz and 2140 MHz, respectively.

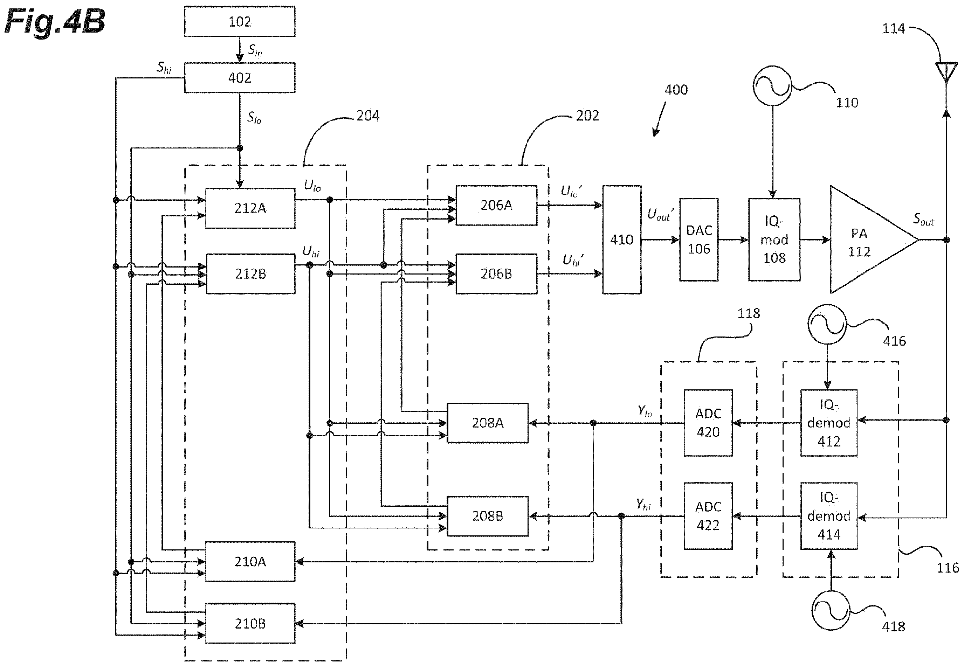

The initial reference signal is provided to the DAC 106, after which it is upconverted at a carrier frequency $F_c$ as determined by the oscillator 110, then amplified using the PA 112 to be output as an output signal ($S_{out}$). In a feedback loop, the output signal ($S_{out}$) as detected is down-converted at two different carrier frequencies ($F_l$ for the lower frequency and $F_h$ for the higher frequency) using two different oscillators 416 and 418 which are capable of providing these two different frequencies. The frequency of the oscillator 416 is lower than the frequency of the oscillator 418, with examples of frequencies for the first and second oscillator frequencies being $F_l$ = 1840 MHz and $F_h$ = 2140 MHz, respectively. The carrier frequencies $F_l$ and $F_h$ may be related to the carrier frequency $F_c$ via the following formula: $F_c = (F_l + F_h) / 2$. Similarly, the downconversion may be implemented using two separate IQ demodulators 412 and 414 (or a single IQ demodulator 116 that is capable of switching between two different frequencies, as shown in Fig. 4B) which implements those two different frequencies. For example, the IQ demodulator 412 may down-convert the feedback signal at the lower frequency $F_l$, after which it is converted using the ADC 420 to generate a low-frequency digital feedback signal ($Y_{lo}$). The IQ demodulator 414 may down-convert the feedback signal at the higher frequency $F_h$, after which it is converted using the ADC 422 to generate a high-frequency digital feedback signal ($Y_{hi}$). In some examples, the ADCs 420 and 422 may be implemented as a single ADC 118, as shown in Fig. 4B (i.e., ADC 118 would only include one of ADCs 420 or 422 instead of both ADCs being implemented in the system).

After the feedback signals are generated, the low-frequency feedback signal ($Y_{lo}$) is provided to a low-frequency secondary DPD layer 204A which also receives the low-frequency input signal ($S_{lo}$) and the high-frequency input signal ($S_{hi}$). The low-frequency feedback signal ($Y_{lo}$) is also provided to a low-frequency primary DPD layer 202A. The high-frequency feedback signal ($Y_{hi}$) is provided to a high-frequency secondary DPD layer 204B which also receives the low-frequency input signal ($S_{lo}$) and the high-frequency input signal ($S_{hi}$). The high-frequency feedback signal ($Y_{hi}$) is also provided to a high-frequency primary DPD layer 202B.

In the low-frequency DPD secondary layer 204A, a low-frequency secondary output signal ($U_{lo}$) is generated based on the low-frequency input signal ($S_{lo}$), the high-frequency input signal ($S_{hi}$), and the low-frequency feedback signal ($Y_{lo}$). In the high-frequency DPD secondary layer 204B, a high-frequency secondary output signal ($U_{hi}$) is generated based on the low-frequency input signal ($S_{lo}$), the high-frequency input signal ($S_{hi}$), and the high-frequency feedback signal ($Y_{hi}$).

The secondary output signals are then provided to the primary DPD layers 202A and 202B. The low-frequency primary DPD layer 202A receives the low-frequency secondary output signal ($U_{lo}$), the high-frequency secondary output signal ($U_{hi}$), and the low-frequency feedback signal ($Y_{lo}$) and uses these to generate a low-frequency primary output signal ($U_{lo}'$). The high-frequency primary DPD layer 202B receives the low-frequency secondary output signal ($U_{lo}$), the high-frequency secondary output signal ($U_{hi}$), and the high-frequency feedback signal ($Y_{hi}$) and uses these to generate a high-frequency primary output signal ($U_{hi}'$). A signal combining module 410 combines the low-frequency primary output signal ($U_{lo}'$) and the high-frequency primary output signal ($U_{hi}'$) by adding them together to generate a predistorted output signal ($U_{out}'$) to be provided to the DAC 106, which is then upconverted by the IQ modulator 108 at frequency $F_c$, and then amplified with the PA 112 to be transmitted as the output signal ($S_{out}$).

Fig. 4B shows the individual components within the primary DPD layer 202 and the secondary DPD layer 204, according to various embodiments. The low-frequency secondary DPD layer 202A implements a low-frequency DPD coefficient estimation module 208A to update low-frequency primary signal generation coefficients based on a low-frequency secondary predistorted signal ($U_{lo}$), a high-frequency secondary predistorted signal ($U_{hi}$), and a low-frequency detected feedback signal ($Y_{lo}$). The low-frequency secondary DPD layer 202A then implements a low-frequency primary distortion compensation processing module 206A to generate a low-frequency primary predistorted signal ($U_{lo}'$) based on the low-frequency secondary predistorted signal ($U_{lo}$) and a high-frequency secondary predistorted signal ($U_{hi}$) using the updated low-frequency primary signal generation coefficients.

The high-frequency primary DPD layer 202B implements a high-frequency DPD coefficient estimation module 208B to update high-frequency primary signal generation coefficients based on the low-frequency secondary predistorted signal ($U_{lo}$), the high-frequency secondary predistorted signal ($U_{hi}$), and a high-frequency detected feedback signal ($Y_{hi}$). The high-frequency primary DPD layer 202B also implements a high-frequency primary distortion compensation processing module 206B to generate a high-frequency primary predistorted signal ($U_{hi}'$) based on the low-frequency secondary predistorted signal ($U_{lo}$) and the high-frequency secondary predistorted signal ($U_{hi}$) using the updated high-frequency primary signal generation coefficients.

The low-frequency secondary DPD layer 204A implements a low-frequency signal characteristic estimation module 210A to update low-frequency secondary signal generation coefficients based on the low-frequency input signal ($S_{lo}$), the high-frequency input signal ($S_{hi}$), and the detected low-frequency feedback signal ($Y_{lo}$). The low-frequency DPD layer 204A also implements a low-frequency secondary distortion compensation processing module 212A to generate the low-frequency secondary predistorted signal ($U_{lo}$) based on the low-frequency input signal ($S_{lo}$) and the high-frequency input signal ($S_{hi}$) using the updated low-frequency secondary signal generation coefficients.

The high-frequency secondary DPD layer 204B implements a high-frequency signal characteristic estimation module 210B to update high-frequency secondary signal generation coefficients based on the low-frequency input signal ($S_{lo}$), the high-frequency input signal ($S_{hi}$), and the detected high-frequency feedback signal ($Y_{hi}$). The high-frequency DPD layer 204B also implements a high-frequency secondary distortion compensation processing module 212B to generate the high-frequency secondary predistorted signal ($U_{hi}$) based on the low-frequency input signal ($S_{lo}$) and the high-frequency input signal ($S_{hi}$) using the updated high-frequency secondary signal generation coefficients.

Any suitable frequencies may be implemented for the aforementioned frequencies $F_c$, $F_l$, and $F_h$. Examples of frequencies for the predistorted low-frequency signal ($U_{lo}$) and predistorted high-frequency signal ($U_{hi}$) may be 1840 MHz and 2140 MHz, respectively. The manner in which the predistorted low-frequency signal ($U_{lo}$) and predistorted high-frequency signal ($U_{hi}$) are generated is described herein and as follows.

In some examples, one or more of the DPD coefficient estimation module(s) 208 and the signal characteristic estimation module(s) 210 may be a processing unit operating with a memory unit with a lookup table which stores therein the values for the low-frequency secondary signal generation coefficients, the high-frequency secondary signal generation coefficients, the low-frequency primary signal generation coefficients, and/or the high-frequency primary signal generation coefficients, as suitable, which may be updated or optimized during subsequent iterations of the cycle of outputting signal transmissions and analyzing the difference (or error margin) between the outputted signal and the initial signal during each iteration, thereby improving the accuracy of the DPD coefficient estimation module(s) 208 and/or the signal characteristic estimation module(s) 210. In some examples, the processing unit of the DPD coefficient estimation module(s) 208 and/or the signal characteristic estimation module(s) 210 may calculate the appropriate coefficients to be implemented for the subsequent cycle using any suitable instructions or algorithms that are configured to determine the updated coefficients in order to reduce the error margin between the input signal and the output signal. In some examples, the calculation may involve solving one or more normal equations based on a least-squares method, or any other suitable method as known in the art.

The low-frequency signal characteristic estimation module 210A performs the comparison between the low-frequency detected feedback signal $Y_{lo}$ and the low-frequency decomposed input signal $S_{lo}$, with the assistance from the high-frequency decomposed input signal $S_{hi}$, to generate the low-frequency secondary signal generation coefficients. The high-frequency signal characteristic estimation module 210B performs the comparison between the high-frequency detected feedback signal $Y_{hi}$ and the high-frequency frequency decomposed input signal $S_{hi}$, with the assistance from the low-frequency decomposed input signal $S_{lo}$, to generate the high-frequency secondary signal generation coefficients. This is shown in Equations 4 and 5, as further discussed herein, used to calculate the predistorted signals, where the low-frequency predistorted signal $y_L(n)$ and the high-frequency predistorted signal $y_U(n)$ are both calculated using the low-frequency and high-frequency decomposed input signals, i.e. $x_L(n)$ and $x_U(n)$. The low-frequency and high-frequency secondary signal generation coefficients are provided to the low-frequency secondary distortion compensation processing module 212A and the high-frequency secondary distortion compensation processing module 212B, respectively, which use them to generate the pre-distorted secondary signals $U_{lo}$ and $U_{hi}$, respectively.

The low-frequency DPD coefficient estimation module 208A performs the comparison between the low-frequency detected feedback signal $Y_{lo}$ and the low-frequency pre-distorted secondary signal $U_{lo}$, with the assistance from the high-frequency pre-distorted secondary signal $U_{hi}$, to generate the low-frequency primary signal generation coefficients. The high-frequency DPD coefficient estimation module 208B performs the comparison between the high-frequency detected feedback signal $Y_{hi}$ and the high-frequency pre-distorted secondary signal $U_{hi}$, with the assistance from the low-frequency pre-distorted secondary signal $U_{lo}$, to generate the high-frequency primary signal generation coefficients. Again, this is shown in Equations 4 and 5, as further discussed herein, used to calculate the predistorted signals, where the low-frequency predistorted signal $y_L(n)$ and the high-frequency predistorted signal $y_U(n)$ are both calculated using the low-frequency and high-frequency decomposed input signals, i.e. $x_L(n)$ and $x_U(n)$. The low-frequency and high-frequency primary signal generation coefficients are provided to the low-frequency primary distortion compensation processing module 206A and the high-frequency primary distortion compensation processing module 206B, respectively, which use them to generate the pre-distorted primary signals $U_{lo}$' and $U_{hi}$', respectively.

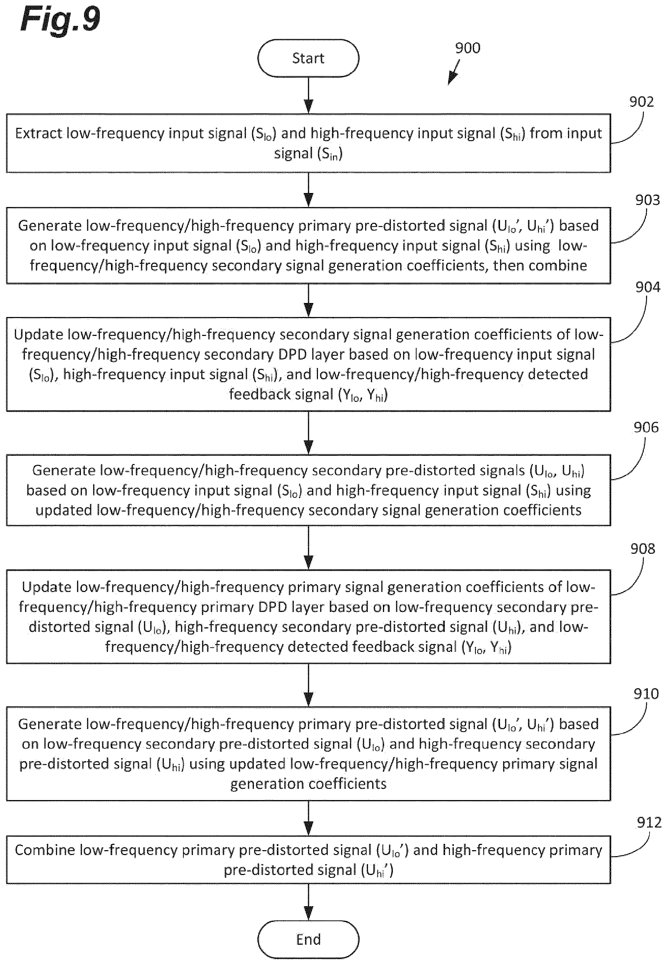

Fig. 9 shows an example of a process 900 performed by the processor 600 according to embodiments disclosed herein. The process 900 may be performed by the processor 600 when the instructions or program codes 604 stored on the non-transitory computer-readable medium or the memory unit 602 are run on the processor 600. The process 900 includes step 902 in which the processor extracts a low-frequency signal ($S_{lo}$) and a high-frequency signal ($S_{hi}$) from an input signal ($S_{in}$) provided by any suitable input signal source. For example, the processor 600 may perform these operations by incorporating and/or utilizing a signal decomposition module 402 as described above. The input signal $S_{in}$ is a composite signal with two component carriers (CC), where the power spectral density (PSD) of the input signal $S_{in}$ is normalized so as to be shifted so that the center of the bandwidth is located at the baseband (0 Hz). The bandwidth of the input signal $S_{in}$ is greater than the bandwidth of each of the two component carriers. The extraction process may involve determining the suitable carrier frequency for each of the signals $S_{lo}$ and $S_{hi}$ and then isolating the input signal at the two determined carrier frequencies to generate the signals $S_{lo}$ and $S_{hi}$. Each PSD of the extracted signals $S_{lo}$ and $S_{hi}$ is normalized, i.e. centered at the baseband (0 Hz), and each PSD of the extracted signals $S_{lo}$ and $S_{hi}$ may have a much smaller bandwidth than the original input signal $S_{in}$.

In step 903, the processor implements the passthrough mode in both the low-frequency and high-frequency secondary DPD layers 204A and 204B, which causes the secondary DPD layers 204A and 204B to output the extracted input signals ($S_{lo}$ or $S_{hi}$, as appropriate) without any distortion compensation applied to the signals, thereby providing the input signals directly to the low-frequency and high-frequency primary DPD layers 202A and 202B, and the primary DPD layers 202A and 202B generate the appropriate low-frequency and high-frequency primary predistorted signals ($U_{lo}$' and $U_{hi}$') based on the extracted input signals ($S_{lo}$ and $S_{hi}$) using the low-frequency and high-frequency primary signal generation coefficients. The primary distorted signals are then combined into a single signal to be transmitted to the amplifier. In step 904, the processor updates the low-frequency secondary signal generation coefficients of a low-frequency secondary DPD layer 204A based on the low-frequency input signal ($S_{lo}$), the high-frequency input signal ($S_{hi}$), and a low-frequency detected feedback signal ($Y_{lo}$). The processor also updates the high-frequency secondary signal generation coefficients of the high-frequency secondary DPD layer 204B based on the low-frequency input signal ($S_{lo}$), the high-frequency input signal ($S_{hi}$), and a high-frequency detected feedback signal ($Y_{hi}$).

In step 906, the processor generates the low-frequency secondary predistorted signal ($U_{lo}$) based on the low-frequency input signal ($S_{lo}$) and the high-frequency input signal ($S_{hi}$) using the updated low-frequency secondary signal generation coefficients. The processor also generates a high-frequency secondary predistorted signal ($U_{hi}$) based on the low-frequency input signal ($S_{lo}$) and the high-frequency input signal ($S_{hi}$) using the updated high-frequency secondary signal generation coefficients.

In step 908, the processor updates low-frequency primary signal generation coefficients of the low-frequency primary DPD layer 202A based on the low-frequency secondary predistorted signal ($U_{lo}$), a high-frequency secondary predistorted signal ($U_{hi}$), and the low-frequency detected feedback signal ($Y_{lo}$). The processor also updates high-frequency primary signal generation coefficients of the high-frequency primary DPD layer (202B) based on the low-frequency secondary predistorted signal ($U_{lo}$), the high-frequency secondary predistorted signal ($U_{hi}$), and the high-frequency detected feedback signal ($Y_{hi}$).

In step 910, the processor generates the low-frequency primary predistorted signal ($U_{lo}'$) based on the low-frequency secondary predistorted signal ($U_{lo}$) and a high-frequency secondary predistorted signal ($U_{hi}$) using the updated low-frequency primary signal generation coefficients. The processor also generates a high-frequency primary predistorted signal ($U_{hi}'$) based on the low-frequency secondary predistorted signal ($U_{lo}$) and the high-frequency secondary predistorted signal ($U_{hi}$) using the updated high-frequency primary signal generation coefficients.

In step 912, the processor combines the low-frequency primary pre-distorted signal ($U_{lo}'$) and the high-frequency primary pre-distorted signal ($U_{hi}'$) to generate the combined predistorted output signal ($U_{out}$). The combined output signal ($U_{out}$) is fed by the processor to the DAC to be converted into an analog signal, to the IQ modulator to be upconverted using the carrier frequency $F_c$, and then to the power amplifier, as previously explained, to be transmitted as an output signal $S_{out}$ by any suitable transmitter. The output signal $S_{out}$ includes distortions caused by the non-linear characteristics of the power amplifier using any suitable transmission format as known in the art, including but not limited to code-division multiple access (CDMA) and orthogonal frequency-division multiplexing (OFDM), which may be vulnerable to PA nonlinearities due to the high peak-to-average power ratio, corresponding to large fluctuations in signal envelopes.

The difference between the central carrier frequency $F_c$ and either of the frequency $F_l$, or $F_h$ is expressed as "X" such that when the input signal $S_{in}$ is centered at the baseband of 0 Hz, the low-frequency component carrier is located at -X Hz, and the high-frequency component carrier is located at X Hz; thus, the distance between the frequencies of the two component carriers is 2*X (also referred to as a wideband spacing between the two component carriers), and therefore the bandwidth of the input signal $S_{in}$ is greater than 2*X. In some examples, if the value of X = 100 MHz, the bandwidth of $S_{in}$ may be approximately 250 MHz. As such, the bandwidth of each of the extracted signals is less than the bandwidth of the original signal. In the above example where X = 100 MHz, the bandwidth of each of the extracted signals may be approximately 5 MHz, 10 MHz, 20 MHz, 30 MHz, 50 MHz, or any other suitable value therebetween, for example. In some examples, the carrier frequencies $F_l$ and $F_h$ may differ by at least about 50 MHz, by at least about 100 MHz, by at least about 150 MHz, by at least 200 MHz, by at least 300 MHz, by at least 350 MHz, or by any other suitable value or range therebetween.

Discussed below is an exemplary implementation of the subject disclosure according to some embodiments as disclosed herein, in which Equation 2 shows that the input signal has low-frequency and high-frequency components; Equation 3 shows that the predistorted output signal also has low-frequency and high-frequency components; and Equations 4-5 show an exemplary method on how to calculate the predistorted low-frequency and high-frequency output signals using the coefficients. In some examples, assuming that the input signal from Equation 1 has two component carriers $x_L$ (lower component carrier) and $x_U$ (upper component carrier), the input signal $x(n)$ can be expressed as follows (with implementation of same taking place within module 402, for example):

$$x(n) = x_L e^{-j\omega_0 t} + x_U e^{j\omega_0 t}$$

(Equation 2)

The predistorted signal $y(n)$ from Equation (1) can then be expressed as follows (with implementation of same taking place within module 410, for example):

$$y(n) = y_L e^{-j\omega_0 t} + y_U e^{j\omega_0 t}$$

(Equation 3)

where $y_L$ and $y_U$ are the predistorted signals based on the following formulas (with the implementation of Equation 4 taking place in modules 206A, 208A, 210A, and 212A, and the implementation of Equation 5 taking place in modules 206B, 208B, 210B, and 212B, for example):

$$y_L(n) =$$

$$\left[ \sum_{l=0}^{N_{lb_{xb}}-1} x_L(n-l) \sum_{m=-N_{mc_{xb}}}^{N_{mb_{xb}}} b_{lm} \sum_{k=1}^{N_{kb_{xb}}} a_{mk} \sum_{i=0}^{k} c_{ki} |x_L(n-l-m)|^{2(k-i)} |x_U(n-l-m)|^{2i} \right] +$$

$$\left[ \sum_{l=0}^{N_{lb_{xb}}-1} x_U(n-l) \sum_{m=-N_{mc_{xb}}}^{N_{mb_{xb}}} b_{lm} \sum_{k=1}^{N_{kb_{xb}}} a_{mk} \sum_{i=0}^{k} c_{ki} |x_L(n-l-m)|^{2(k-1-i)} |x_U(n-l-m)|^{2i} x_L(n-l) \right.$$

$$\left. -m) x_U^*(n-l-m) \right] +$$

$$\left[ \sum_{l=0}^{N_{la_{xbim}}-1} x_U^*(n-l) \sum_{k=0}^{N_{ka_{xbim}}-1} b_{lk} \sum_{i=0}^{k} c_{ki} |x_U(n-l)|^{2i} |x_L(n-l)|^{2(k-i)} \right]$$

(Equation 4)

$$y_U(n) =$$

$$\left[\sum_{l=0}^{N_{lb_{xb}}-1} x_U(n-l) \sum_{m=-N_{mc_{xb}}}^{N_{mb_{xb}}} b_{lm} \sum_{k=1}^{N_{kb_{xb}}} a_{mk} \sum_{i=0}^{k} c_{ki}|x_U(n-l-m)|^{2(k-i)}|x_L(n-l-m)|^{2i}\right] +$$

$$\left[\sum_{l=0}^{N_{lb_{xb}}-1} x_L(n-l) \sum_{m=-N_{mc_{xb}}}^{N_{mb_{xb}}} b_{lm} \sum_{k=1}^{N_{kb_{xb}}} a_{mk} \sum_{i=0}^{k} c_{ki}|x_U(n-l-m)|^{2(k-1-i)}|x_L(n-l-m)|^{2i} x_U(n-l\right.$$

$$\left.-m)x_L^*(n-l-m)\right] +$$

$$\left[\sum_{l=0}^{N_{la_{xbim}}-1} x_L^*(n-l) \sum_{k=0}^{N_{ka_{xbim}}-1} b_{lk} \sum_{i=0}^{k} a_{mk}|x_L(n-l)|^{2i}|x_U(n-l)|^{2(k-i)}\right]$$

(Equation 5)

where:

$N_{lb_{xb}}$ is the cross-band memory depth;

$N_{mb_{xb}}$ is the cross-band backward cross term length;

$N_{mc_{xb}}$ is the cross-band backward cross term length;

$N_{kb_{xb}}$ is the cross-band nonlinearity order;

$N_{la_{xbim}}$ is the cross-band image memory depth;

$N_{ka_{xbim}}$ is the cross-band image nonlinearity order;

$a_{mk}$, $b_{lk}$, $b_{lm}$, and $c_{ki}$ are the signal generation coefficients which may be stored in the memory as a matrix or a table;

$x_U^*$ is the conjugative signal of $x_U$; and

$x_L^*$ is the conjugative signal of $x_L$.

Advantages of implementing the signal transmission device or system as disclosed herein include the reduction in bandwidth necessary to process the input and output signals in determining the coefficients to be implemented for distortion compensation. By decomposing a signal into two separate signals, each with a component carrier at a frequency different from the other, the signal processing can be performed using a narrower bandwidth which encompasses only one of the component carriers instead of both the component carriers, as known in the art. As such, the reduction in processing bandwidth improves the efficiency of signal processing by reducing the processing load for updating the distortion compensation characteristics. Reduction in processing load allows the processor to more frequently perform updates of the distortion compensation characteristics (that is, the signal generation coefficients) in preparation for a change in distortion.

**Implementation 4**

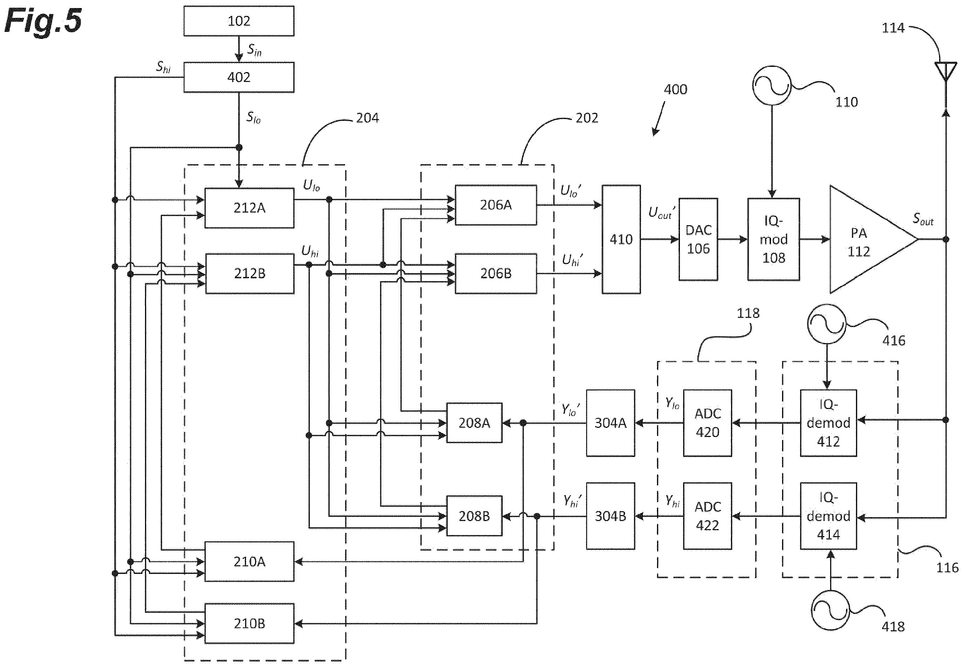

Fig. 5 illustrates an example of a signal transmission device or system 500 as disclosed herein. It is to be understood that in some examples, each of the functional blocks in the figures may be implemented as an individual component, or a plurality of functional blocks may be implemented together in a component, as suitable for designing, manufacturing, or operating the device or system. The system 500 includes all the components in the system 400 shown in Fig. 4B, and operates in a similar way, but additionally includes the IMD filter module 304 from Fig. 3 located downstream of the ADC 118.

The ADC 118 (or ADCs 420 and 422, if there are two separate converters or feedback loops) converts the down-converted feedback signals, generated by obtaining the detected output signal ($S_{out}$) and down-converting it using two different carrier frequencies $F_l$ and $F_h$ as previously discussed, into a low-frequency feedback signal ($Y_{lo}$) and a high-frequency feedback signal ($Y_{hi}$). The low-frequency feedback signal ($Y_{lo}$) is passed through a low-frequency IMD filter module 304A to generate a targeted low-frequency filtered signal ($Y_{lo}'$). The high-frequency feedback signal ($Y_{hi}$) is passed through a high-frequency IMD filter module 304B to generate a targeted low-frequency filtered signal ($Y_{hi}'$). Subsequently, the targeted low-frequency filtered signal ($Y_{lo}'$) is used in any coefficient calculation that requires the low-frequency feedback signal ($Y_{lo}$) as an input in the system 400 of Fig. 4B, and the targeted high-frequency filtered signal ($Y_{hi}'$) is used in any coefficient calculations that requires the high-frequency feedback signal ($Y_{hi}$) as an input in the system 400.

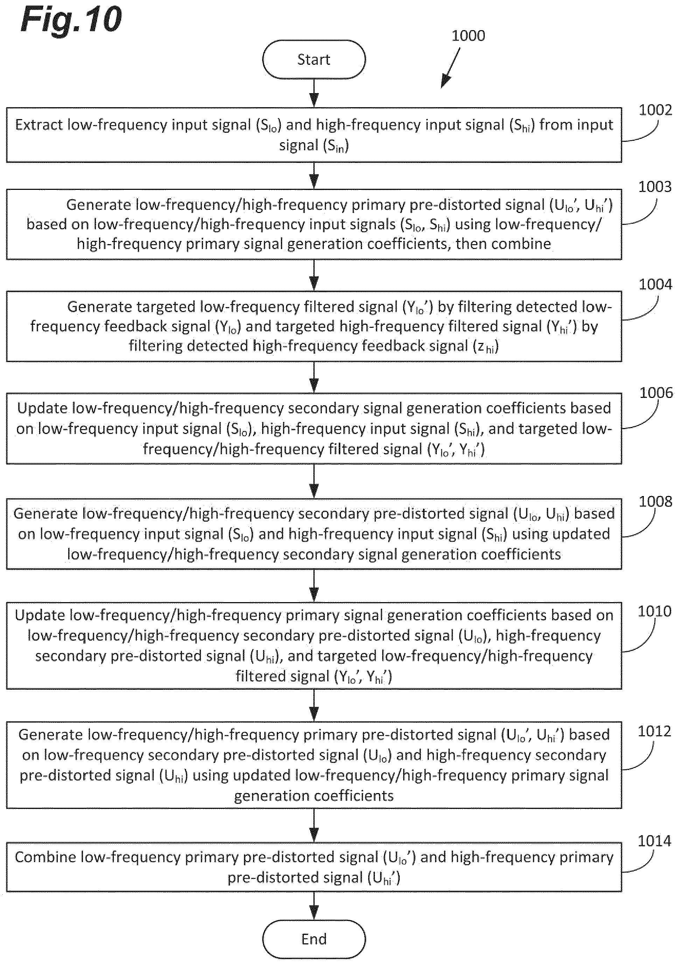

Fig. 10 shows an example of a process 1000 performed by the processor 600 according to embodiments disclosed herein. The process 1000 may be performed by the processor 600 when the instructions or program codes 604 stored on the non-transitory computer-readable medium or the memory unit 602 are run on the processor 600. The process 1000 includes step 1002 in which the processor extracts a low-frequency signal ($S_{lo}$) and a high-frequency signal ($S_{hi}$) from an input signal ($S_{in}$) provided by any suitable input signal source.

In step 1003, the processor implements the passthrough mode in both the low-frequency and high-frequency secondary DPD layers 204A and 204B, which causes the secondary DPD layers 204A and 204B to output the extracted input signals ($S_{lo}$ or $S_{hi}$, as appropriate) without any distortion compensation applied to the signals, thereby providing the input signals directly to the low-frequency and high-frequency primary DPD layers 202A and 202B, and the primary DPD layers 202A and 202B generate the appropriate low-frequency and high-frequency primary predistorted signals ($U_{lo}'$ and $U_{hi}'$) based on the extracted input signals ($S_{lo}$ and $S_{hi}$) using the low-frequency and high-frequency primary signal generation coefficients. The primary distorted signals are then combined into a single signal to be transmitted to the amplifier. In step 1004, the processor generates a targeted low-frequency filtered signal ($Y_{lo}'$) by filtering a detected low-frequency feedback signal ($Y_{lo}$). The processor also generates a targeted high-frequency filtered signal ($Y_{hi}'$) by filtering a detected high-frequency feedback signal ($Y_{hi}$).

In step 1006, the processor updates the low-frequency secondary signal generation coefficients of a low-frequency secondary DPD layer 204A based on the low-frequency input signal ($S_{lo}$), the high-frequency input signal ($S_{hi}$), and the targeted low-frequency filtered signal ($Y_{lo}'$). The processor also updates the high-frequency secondary signal generation coefficients of the high-frequency secondary DPD layer 204B based on the low-frequency input signal ($S_{lo}$), the high-frequency input signal ($S_{hi}$), and the targeted high-frequency filtered signal ($Y_{hi}'$).

In step 1008, the processor generates the low-frequency secondary predistorted signal ($U_{lo}$) based on the low-frequency input signal ($S_{lo}$) and the high-frequency input signal ($S_{hi}$) using the updated low-frequency secondary signal generation coefficients. The processor also generates a high-frequency secondary predistorted signal ($U_{hi}$) based on the low-frequency input signal ($S_{lo}$) and the high-frequency input signal ($S_{hi}$) using the updated high-frequency secondary signal generation coefficients.

In step 1010, the processor updates low-frequency primary signal generation coefficients of the low-frequency primary DPD layer 202A based on the low-frequency secondary predistorted signal ($U_{lo}$), a high-frequency secondary predistorted signal ($U_{hi}$), and the targeted low-frequency filtered signal ($Y_{lo}'$). The processor also updates high-frequency primary signal generation coefficients of the high-frequency primary DPD layer (202B) based on the low-frequency secondary predistorted signal ($U_{lo}$), the high-frequency secondary predistorted signal ($U_{hi}$), and the targeted high-frequency filtered signal ($Y_{hi}'$).

In step 1012, the processor generates the low-frequency primary predistorted signal ($U_{lo}'$) based on the low-frequency secondary predistorted signal ($U_{lo}$) and a high-frequency secondary predistorted signal ($U_{hi}$) using the updated low-frequency primary signal generation coefficients. The processor also generates a high-frequency primary predistorted signal ($U_{hi}'$) based on the low-frequency secondary predistorted signal ($U_{lo}$) and the high-frequency secondary predistorted signal ($U_{hi}$) using the updated high-frequency primary signal generation coefficients.

In step 1014, the processor combines the low-frequency primary pre-distorted signal ($U_{lo}'$) and the high-frequency primary pre-distorted signal ($U_{hi}'$) to generate the combined predistorted output signal ($U_{out}$). The combined output signal ($U_{out}$) is fed by the processor to the DAC to be converted into an analog signal, to the IQ modulator to be upconverted using the carrier frequency $F_c$, and then to the power amplifier, as previously explained, to be transmitted as an output signal $S_{out}$ by any suitable transmitter. The output signal $S_{out}$ includes distortions caused by the non-linear characteristics of the power amplifier using any suitable transmission format as known in the art.

The present subject matter may be embodied in other specific forms without departing from the scope of the present disclosure. The described embodiments are to be considered in all respects only as illustrative and not restrictive. Those skilled in the art will recognize that other implementations consistent with the disclosed embodiments are possible. The above detailed description and the examples described therein have been presented for the purposes of illustration and description only and not for limitation. For example, the operations described can be done in any suitable manner. The methods can be performed in any suitable order while still providing the described operation and results. It is therefore contemplated that the present embodiments cover any and all modifications, variations, or equivalents that fall within the scope of the basic underlying principles disclosed above and claimed herein. Furthermore, while the above description describes hardware in the form of a processor executing code, hardware in the form of a state machine, or dedicated logic capable of producing the same effect, other structures are also contemplated.

In the following embodiments of the present invention are listed.

1. A transmitter system comprising:

a primary digital predistortion (DPD) layer comprising:

a DPD coefficient estimation module configured to update primary signal generation coefficients based on comparing a secondary predistorted signal ($U_{out}$) with a detected feedback signal ($Y_{out}$), and
a primary distortion compensation processing module configured to generate a primary predistorted signal ($U_{out}$') based on the secondary predistorted signal ($U_{out}$) using the updated primary signal generation coefficients; and

a secondary DPD layer comprising:

a signal characteristic estimation module configured to update secondary signal generation coefficients based on comparing an input signal ($S_{in}$) with the detected feedback signal ($Y_{out}$), and
a secondary distortion compensation processing module configured to generate the secondary predistorted signal ($U_{out}$) based on the input signal ($S_{in}$) using the updated secondary signal generation coefficients.

2. The system of claim 1, wherein the primary DPD layer is configured to update the primary signal generation coefficients by performing direct or indirect learning, and the secondary DPD layer is configured to update the secondary signal generation coefficients by performing direct learning.

3. The system of embodiment 2, wherein the direct learning includes:

comparing the input signal ($S_{in}$) with an output signal ($S_{out}$) from an amplifier to determine a difference between the input and output signals; and
applying inverse modeling to update the primary or secondary signal generation coefficients in order to reduce the difference between the input and output signals.

4. The system of embodiment 2 or 3, wherein the indirect learning includes:

comparing the input signal ($S_{in}$) with an output signal ($S_{out}$) from an amplifier to determine an error signal;
decomposing the error signal into nonlinear terms; and
applying adaptive model learning to update the primary signal generation coefficients by subtracting the nonlinear terms of the error signal from the secondary predistorted signal ($U_{out}$).

5. A method comprising:

updating, by a signal characteristic estimation module of a secondary digital predistortion (DPD) layer, secondary signal generation coefficients based on comparing an input signal ($S_{in}$) with a detected feedback signal ($Y_{out}$);
generating, by a secondary distortion compensation processing module of the secondary DPD layer, a secondary predistorted signal ($U_{out}$) based on the input signal ($S_{in}$) using the updated secondary signal generation coefficients;
updating, by a DPD coefficient estimation module of a primary DPD layer, primary signal generation coefficients based on comparing the secondary predistorted signal ($U_{out}$) with the detected feedback signal ($Y_{out}$), and

generating, by a primary distortion compensation processing module of the primary DPD layer, a primary pre-distorted signal ($U_{out}'$) based on the secondary predistorted signal ($U_{out}$) using the updated primary signal generation coefficients.

6. The method of embodiment 5, wherein the primary signal generation coefficients are updated by performing direct or indirect learning, and the secondary signal generation coefficients are updated by performing indirect learning.

7. The method of embodiment 6, wherein the direct learning is performed by:

comparing the input signal ($S_{in}$) with an output signal ($S_{out}$) from an amplifier to determine a difference between the input and output signals; and
applying inverse modeling to update the primary or secondary signal generation coefficients in order to reduce the difference between the input and output signals.

8. The method of embodiment 6 or 7, wherein the indirect learning is performed by:

comparing the input signal ($S_{in}$) with an output signal ($S_{out}$) from an amplifier to determine an error signal;
decomposing the error signal into nonlinear terms; and
applying adaptive model learning to update the primary signal generation coefficients by subtracting the nonlinear terms of the error signal from the secondary predistorted signal ($U_{out}$).

9. A non-transitory computer-readable medium storing instructions therein which, when run on a processor, causes the processor to:

update secondary signal generation coefficients of a secondary digital predistortion (DPD) layer based on comparing an input signal ($S_{in}$) with a detected feedback signal ($Y_{out}$);
generate a secondary predistorted signal ($U_{out}$) based on the input signal ($S_{in}$) using the updated secondary signal generation coefficients;
update primary signal generation coefficients of a primary DPD layer based on comparing the secondary pre-distorted signal ($U_{out}$) with the detected feedback signal ($Y_{out}$); and
generate a primary predistorted signal ($U_{out}'$) based on the secondary predistorted signal ($U_{out}$) using the updated primary signal generation coefficients.

10. The computer-readable medium of embodiment 9, wherein the primary signal generation coefficients are updated by performing direct or indirect learning, and the secondary signal generation coefficients are updated by performing indirect learning.

11. The computer-readable medium of embodiment 10, wherein the instructions further cause the processor to perform the direct learning by:

comparing the input signal ($S_{in}$) with an output signal ($S_{out}$) from an amplifier to determine a difference between the input and output signals; and
applying inverse modeling to update the primary or secondary signal generation coefficients in order to reduce the difference between the input and output signals.

12. The computer-readable medium of embodiment 10 or 11, wherein the instructions further cause the processor to perform the indirect learning by:

comparing the input signal ($S_{in}$) with an output signal ($S_{out}$) from an amplifier to determine an error signal;
decomposing the error signal into nonlinear terms; and
applying adaptive model learning to update the primary signal generation coefficients by subtracting the nonlinear terms of the error signal from the secondary predistorted signal ($U_{out}$).

13. A transmitter system comprising:

an intermodulation distortion filter module configured to filter a detected feedback signal ($Y_{in}$) to generate a targeted filtered signal ($Y_{out}$);
a primary digital predistortion (DPD) layer comprising:

a DPD coefficient estimation module configured to update primary signal generation coefficients based on comparing a secondary predistorted signal ($U_{out}$) with a targeted filtered signal ($Y_{out}$), and

a primary distortion compensation processing module configured to generate a primary predistorted signal ($U_{out}$') based on the secondary predistorted signal ($U_{out}$) using the updated primary signal generation coefficients; and

a secondary DPD layer comprising:

a signal characteristic estimation module configured to update secondary signal generation coefficients based on comparing an input signal ($S_{in}$) with a targeted filtered signal ($Y_{out}$), and

a secondary distortion compensation processing module configured to generate the secondary predistorted signal ($U_{out}$) based on the input signal ($S_{in}$) using the updated secondary signal generation coefficients.

14. The system of embodiment 13, wherein the primary DPD layer is configured to update the primary signal generation coefficients by performing direct or indirect learning, and the secondary DPD layer is configured to update the secondary signal generation coefficients by performing indirect learning.

15. A method comprising:

filtering, by an intermodulation distortion filter module, a detected feedback signal ($Y_{in}$) to generate a targeted filtered signal ($Y_{out}$);

updating, by a signal characteristic estimation module of a secondary digital predistortion (DPD) layer, secondary signal generation coefficients based on comparing an input signal ($S_{in}$) with a targeted feedback signal ($Y_{out}$);

generating, by a secondary distortion compensation processing module of the secondary DPD layer, a secondary predistorted signal ($U_{out}$) based on the input signal ($S_{in}$) using the updated secondary signal generation coefficients;

updating, by a DPD coefficient estimation module of a primary DPD layer, primary signal generation coefficients based on comparing the secondary predistorted signal ($U_{out}$) with the targeted feedback signal ($Y_{out}$), and

generating, by a primary distortion compensation processing module of the primary DPD layer, a primary predistorted signal ($U_{out}$') based on the secondary predistorted signal ($U_{out}$) using the updated primary signal generation coefficients.

16. The method of embodiment 15, wherein the primary signal generation coefficients are updated by performing direct or indirect learning, and the secondary signal generation coefficients are updated by performing indirect learning.

17. A non-transitory computer-readable medium storing instructions therein which, when run on a processor, causes the processor to:

filter a detected feedback signal ($Y_{in}$) to generate a targeted filtered signal ($Y_{out}$);

update secondary signal generation coefficients of a secondary digital predistortion (DPD) layer based on comparing an input signal ($S_{in}$) with a targeted feedback signal ($Y_{out}$);

generate a secondary predistorted signal ($U_{out}$) based on the input signal ($S_{in}$) using the updated secondary signal generation coefficients;

update primary signal generation coefficients of a primary DPD layer based on comparing the secondary predistorted signal ($U_{out}$) with the targeted feedback signal ($Y_{out}$), and

generate a primary predistorted signal ($U_{out}$') based on the secondary predistorted signal ($U_{out}$) using the updated primary signal generation coefficients.

18. The computer-readable medium of embodiment 17, wherein the primary signal generation coefficients are updated by performing direct or indirect learning, and the secondary signal generation coefficients are updated by performing indirect learning.

19. A transmitter system comprising:

a signal decomposition module configured to extract a low-frequency input signal ($S_{lo}$) and a high-frequency input signal ($S_{hi}$) from an input signal ($S_{in}$);

a low-frequency primary digital predistortion (DPD) layer comprising:

a low-frequency DPD coefficient estimation module configured to update low-frequency primary signal generation coefficients based on a low-frequency secondary predistorted signal ($U_{lo}$), a high-frequency secondary predistorted signal ($U_{hi}$), and a low-frequency detected feedback signal ($Y_{lo}$), and

a low-frequency primary distortion compensation processing module configured to generate a low-frequency primary predistorted signal ($U_{lo}'$) based on the low-frequency secondary predistorted signal ($U_{lo}$) and a high-frequency secondary predistorted signal ($U_{hi}$) using the updated low-frequency primary signal generation coefficients;

a high-frequency primary DPD layer comprising:

a high-frequency DPD coefficient estimation module configured to update high-frequency primary signal generation coefficients based on the low-frequency secondary predistorted signal ($U_{lo}$), the high-frequency secondary predistorted signal ($U_{hi}$), and a high-frequency detected feedback signal ($Y_{hi}$), and

a high-frequency primary distortion compensation processing module configured to generate a high-frequency primary predistorted signal ($U_{hi}'$) based on the low-frequency secondary predistorted signal ($U_{lo}$) and the high-frequency secondary predistorted signal ($U_{hi}$) using the updated high-frequency primary signal generation coefficients;

a signal combining module configured to combine the low-frequency primary predistorted signal ($U_{lo}'$) and the high-frequency primary predistorted signal ($U_{hi}'$);

a low-frequency secondary DPD layer comprising:

a low-frequency signal characteristic estimation module configured to update low-frequency secondary signal generation coefficients based on the low-frequency input signal ($S_{lo}$), the high-frequency input signal ($S_{hi}$), and the detected low-frequency feedback signal ($Y_{lo}$), and

a low-frequency secondary distortion compensation processing module configured to generate the low-frequency secondary predistorted signal ($U_{lo}$) based on the low-frequency input signal ($S_{lo}$) and the high-frequency input signal ($S_{hi}$) using the updated low-frequency secondary signal generation coefficients; and

a high-frequency secondary DPD layer comprising:

a high-frequency signal characteristic estimation module configured to update high-frequency secondary signal generation coefficients based on the low-frequency input signal ($S_{lo}$), the high-frequency input signal ($S_{hi}$), and the detected high-frequency feedback signal ($Y_{hi}$), and

a high-frequency secondary distortion compensation processing module configured to generate the high-frequency secondary predistorted signal ($U_{hi}$) based on the low-frequency input signal ($S_{lo}$) and the high-frequency input signal ($S_{hi}$) using the updated high-frequency secondary signal generation coefficients.

20. A method comprising:

extracting, by a signal decomposition module, a low-frequency input signal ($S_{lo}$) and a high-frequency input signal ($S_{hi}$) from an input signal ($S_{in}$);

updating, by a low-frequency signal characteristic estimation module of a low-frequency secondary digital predistortion (DPD) layer, low-frequency secondary signal generation coefficients based on the low-frequency input signal ($S_{lo}$), the high-frequency input signal ($S_{hi}$), and a low-frequency detected feedback signal ($Y_{lo}$);

generating, by a low-frequency secondary distortion compensation processing module of the low-frequency secondary DPD layer, a low-frequency secondary predistorted signal ($U_{lo}$) based on the low-frequency input signal ($S_{lo}$) and the high-frequency input signal ($S_{hi}$) using the updated low-frequency secondary signal generation coefficients;

updating, by a high-frequency signal characteristic estimation module of a high-frequency secondary DPD layer, high-frequency secondary signal generation coefficients based on the low-frequency input signal ($S_{lo}$), the high-frequency input signal ($S_{hi}$), and a high-frequency detected feedback signal ($Y_{hi}$);

generating, by a high-frequency secondary distortion compensation processing module of the high-frequency secondary DPD layer, a high-frequency secondary predistorted signal ($U_{hi}$) based on the low-frequency input signal ($S_{lo}$) and the high-frequency input signal ($S_{hi}$) using the updated high-frequency secondary signal generation coefficients;

updating, by a low-frequency DPD coefficient estimation module of a low-frequency primary DPD layer, low-frequency primary signal generation coefficients based on a low-frequency secondary predistorted signal ($U_{lo}$),

a high-frequency secondary predistorted signal ($U_{hi}$), and the low-frequency detected feedback signal ($Y_{lo}$);

generating, by a low-frequency primary distortion compensation processing module of the low-frequency primary DPD layer, a low-frequency primary predistorted signal ($U_{lo}'$) based on the low-frequency secondary predistorted signal ($U_{lo}$) and a high-frequency secondary predistorted signal ($U_{hi}$) using the updated low-frequency primary signal generation coefficients;

updating, by a high-frequency DPD coefficient estimation module of a high-frequency primary DPD layer, high-frequency primary signal generation coefficients based on the low-frequency secondary predistorted signal ($U_{lo}$), the high-frequency secondary predistorted signal ($U_{hi}$), and the high-frequency detected feedback signal ($Y_{hi}$);

generating, by a high-frequency primary distortion compensation processing module of the high-frequency primary DPD layer, a high-frequency primary predistorted signal ($U_{hi}'$) based on the low-frequency secondary predistorted signal ($U_{lo}$) and the high-frequency secondary predistorted signal ($U_{hi}$) using the updated high-frequency primary signal generation coefficients; and

combining, by a signal combining module, the low-frequency primary predistorted signal ($U_{lo}'$) and the high-frequency primary predistorted signal ($U_{hi}'$).

21. A non-transitory computer-readable medium storing instructions therein which, when run on a processor, causes the processor to:

extract a low-frequency input signal ($S_{lo}$) and a high-frequency input signal ($S_{hi}$) from an input signal ($S_{in}$);

update low-frequency secondary signal generation coefficients of a low-frequency secondary digital predistortion (DPD) layer based on the low-frequency input signal ($S_{lo}$), the high-frequency input signal ($S_{hi}$), and a low-frequency detected feedback signal ($Y_{lo}$);

generate a low-frequency secondary predistorted signal ($U_{lo}$) based on the low-frequency input signal ($S_{lo}$) and the high-frequency input signal ($S_{hi}$) using the updated low-frequency secondary signal generation coefficients;

update high-frequency secondary signal generation coefficients of a high-frequency secondary DPD layer based on the low-frequency input signal ($S_{lo}$), the high-frequency input signal ($S_{hi}$), and a high-frequency detected feedback signal ($Y_{hi}$);

generate a high-frequency secondary predistorted signal ($U_{hi}$) based on the low-frequency input signal ($S_{lo}$) and the high-frequency input signal ($S_{hi}$) using the updated high-frequency secondary signal generation coefficients;

update low-frequency primary signal generation coefficients of a low-frequency primary DPD layer based on a low-frequency secondary predistorted signal ($U_{lo}$), a high-frequency secondary predistorted signal ($U_{hi}$), and the low-frequency detected feedback signal ($Y_{lo}$);

generate a low-frequency primary predistorted signal ($U_{lo}'$) based on the low-frequency secondary predistorted signal ($U_{lo}$) and a high-frequency secondary predistorted signal ($U_{hi}$) using the updated low-frequency primary signal generation coefficients;

update high-frequency primary signal generation coefficients of a high-frequency primary DPD layer based on the low-frequency secondary predistorted signal ($U_{lo}$), the high-frequency secondary predistorted signal ($U_{hi}$), and the high-frequency detected feedback signal ($Y_{hi}$);

generate a high-frequency primary predistorted signal ($U_{hi}'$) based on the low-frequency secondary predistorted signal ($U_{lo}$) and the high-frequency secondary predistorted signal ($U_{hi}$) using the updated high-frequency primary signal generation coefficients; and

combine the low-frequency primary predistorted signal ($U_{lo}'$) and the high-frequency primary predistorted signal ($U_{hi}'$).

22. A transmitter system comprising:

a signal decomposition module configured to extract a low-frequency input signal ($S_{lo}$) and a high-frequency input signal ($S_{hi}$) from an input signal ($S_{in}$);

a low-frequency intermodulation distortion filter module configured to filter a detected low-frequency feedback signal ($Y_{lo}$) to generate a targeted low-frequency filtered signal ($Y_{lo}'$);

a high-frequency intermodulation distortion filter module configured to filter a detected high-frequency feedback signal ($Y_{hi}$) to generate a targeted high-frequency filtered signal ($Y_{hi}'$);

a low-frequency primary digital predistortion (DPD) layer comprising:

a low-frequency DPD coefficient estimation module configured to update low-frequency primary signal generation coefficients based on a low-frequency secondary predistorted signal ($U_{lo}$), a high-frequency

secondary predistorted signal ($U_{hi}$), and the targeted low-frequency filtered signal ($Y_{lo}'$), and

a low-frequency primary distortion compensation processing module configured to generate a low-frequency primary predistorted signal ($U_{lo}'$) based on the low-frequency secondary predistorted signal ($U_{lo}$) and a high-frequency secondary predistorted signal ($U_{hi}$) using the updated low-frequency primary signal generation coefficients;

a high-frequency primary DPD layer comprising:

a high-frequency DPD coefficient estimation module configured to update high-frequency primary signal generation coefficients based on the low-frequency secondary predistorted signal ($U_{lo}$), the high-frequency secondary predistorted signal ($U_{hi}$), and the targeted high-frequency filtered signal ($Y_{hi}'$), and

a high-frequency primary distortion compensation processing module configured to generate a high-frequency primary predistorted signal ($U_{hi}'$) based on the low-frequency secondary predistorted signal ($U_{lo}$) and the high-frequency secondary predistorted signal ($U_{hi}$) using the updated high-frequency primary signal generation coefficients;

a signal combining module configured to combine the low-frequency primary predistorted signal ($U_{lo}'$) and the high-frequency primary predistorted signal ($U_{hi}'$);

a low-frequency secondary DPD layer comprising:

a low-frequency signal characteristic estimation module configured to update low-frequency secondary signal generation coefficients based on the low-frequency input signal ($S_{lo}$), the high-frequency input signal ($S_{hi}$), and the targeted low-frequency filtered signal ($Y_{lo}'$), and

a low-frequency secondary distortion compensation processing module configured to generate the low-frequency secondary predistorted signal ($U_{lo}$) based on the low-frequency input signal ($S_{lo}$) and the high-frequency input signal ($S_{hi}$) using the updated low-frequency secondary signal generation coefficients; and

a high-frequency secondary DPD layer comprising:

a high-frequency signal characteristic estimation module configured to update high-frequency secondary signal generation coefficients based on the low-frequency input signal ($S_{lo}$), the high-frequency input signal ($S_{hi}$), and the targeted high-frequency filtered signal ($Y_{hi}'$), and

a high-frequency secondary distortion compensation processing module configured to generate the high-frequency secondary predistorted signal ($U_{hi}$) based on the low-frequency input signal ($S_{lo}$) and the high-frequency input signal ($S_{hi}$) using the updated high-frequency secondary signal generation coefficients.

23. A method comprising:

extracting, by a signal decomposition module, a low-frequency input signal ($S_{lo}$) and a high-frequency input signal ($S_{hi}$) from an input signal ($S_{in}$);

generating, by a low-frequency intermodulation distortion filter module, a targeted low-frequency filtered signal ($Y_{lo}'$) by filtering a detected low-frequency feedback signal ($Y_{lo}$);

generating, by a high-frequency intermodulation distortion filter module, a targeted high-frequency filtered signal ($Y_{hi}'$) by filtering a detected high-frequency feedback signal ($Y_{hi}$);

updating, by a low-frequency signal characteristic estimation module of a low-frequency secondary digital predistortion (DPD) layer, low-frequency secondary signal generation coefficients based on the low-frequency input signal ($S_{lo}$), the high-frequency input signal ($S_{hi}$), and the targeted low-frequency filtered signal ($Y_{lo}'$);

generating, by a low-frequency secondary distortion compensation processing module of the low-frequency secondary DPD layer, a low-frequency secondary predistorted signal ($U_{lo}$) based on the low-frequency input signal ($S_{lo}$) and the high-frequency input signal ($S_{hi}$) using the updated low-frequency secondary signal generation coefficients;

updating, by a high-frequency signal characteristic estimation module of a high-frequency secondary DPD layer, high-frequency secondary signal generation coefficients based on the low-frequency input signal ($S_{lo}$), the high-frequency input signal ($S_{hi}$), and the targeted high-frequency filtered signal ($Y_{hi}'$);

generating, by a high-frequency secondary distortion compensation processing module of the high-frequency secondary DPD layer, a high-frequency secondary predistorted signal ($U_{hi}$) based on the low-frequency input signal ($S_{lo}$) and the high-frequency input signal ($S_{hi}$) using the updated high-frequency secondary signal generation coefficients;

updating, by a low-frequency DPD coefficient estimation module of a low-frequency primary DPD layer, low-frequency primary signal generation coefficients based on the low-frequency secondary predistorted signal ($U_{lo}$), the high-frequency secondary predistorted signal ($U_{hi}$), and the targeted low-frequency filtered signal ($Y_{lo}'$); generating, by a low-frequency primary distortion compensation processing module of the low-frequency primary DPD layer, a low-frequency primary predistorted signal ($U_{lo}'$) based on the low-frequency secondary predistorted signal ($U_{lo}$) and the high-frequency secondary predistorted signal ($U_{hi}$) using the updated low-frequency primary signal generation coefficients;

updating, by a high-frequency DPD coefficient estimation module of a high-frequency primary DPD layer, high-frequency primary signal generation coefficients based on the low-frequency secondary predistorted signal ($U_{lo}$), the high-frequency secondary predistorted signal ($U_{hi}$), and the targeted high-frequency filtered signal ($Y_{hi}'$); generating, by a high-frequency primary distortion compensation processing module of the high-frequency primary digital predistortion layer, a high-frequency primary predistorted signal ($U_{hi}'$) based on the low-frequency secondary predistorted signal ($U_{lo}$) and the high-frequency secondary predistorted signal ($U_{hi}$) using the updated high-frequency primary signal generation coefficients; and

combining, by a signal combining module, the low-frequency primary predistorted signal ($U_{lo}'$) and the high-frequency primary predistorted signal ($U_{hi}'$).

24. A non-transitory computer-readable medium storing instructions therein which, when run on a processor, causes the processor to:

extract a low-frequency input signal ($S_{lo}$) and a high-frequency input signal ($S_{hi}$) from an input signal ($S_{in}$);
generate a targeted low-frequency filtered signal ($Y_{lo}'$) by filtering a detected low-frequency feedback signal ($Y_{lo}$);
generate a targeted high-frequency filtered signal ($Y_{hi}'$) by filtering a detected high-frequency feedback signal ($Y_{hi}$);
update low-frequency secondary signal generation coefficients based on the low-frequency input signal ($S_{lo}$), the high-frequency input signal ($S_{hi}$), and the targeted low-frequency filtered signal ($Y_{lo}'$);
generate a low-frequency secondary predistorted signal ($U_{lo}$) based on the low-frequency input signal ($S_{lo}$) and the high-frequency input signal ($S_{hi}$) using the updated low-frequency secondary signal generation coefficients;
update high-frequency secondary signal generation coefficients based on the low-frequency input signal ($S_{lo}$), the high-frequency input signal ($S_{hi}$), and the targeted high-frequency filtered signal ($Y_{hi}'$);
generate a high-frequency secondary predistorted signal ($U_{hi}$) based on the low-frequency input signal ($S_{lo}$) and the high-frequency input signal ($S_{hi}$) using the updated high-frequency secondary signal generation coefficients;
update low-frequency primary signal generation coefficients based on the low-frequency secondary predistorted signal ($U_{lo}$), the high-frequency secondary predistorted signal ($U_{hi}$), and the targeted low-frequency filtered signal ($Y_{lo}'$);
generate a low-frequency primary predistorted signal ($U_{lo}'$) based on the low-frequency secondary predistorted signal ($U_{lo}$) and the high-frequency secondary predistorted signal ($U_{hi}$) using the updated low-frequency primary signal generation coefficients;
update high-frequency primary signal generation coefficients based on the low-frequency secondary predistorted signal ($U_{lo}$), the high-frequency secondary predistorted signal ($U_{hi}$), and the targeted high-frequency filtered signal ($Y_{hi}'$);
generate a high-frequency primary predistorted signal ($U_{hi}'$) based on the low-frequency secondary predistorted signal ($U_{lo}$) and the high-frequency secondary predistorted signal ($U_{hi}$) using the updated high-frequency primary signal generation coefficients; and
combine the low-frequency primary predistorted signal ($U_{lo}'$) and the high-frequency primary predistorted signal ($U_{hi}'$).

## Claims

1. A transmitter system comprising:

a primary digital predistortion (DPD) layer comprising:

a DPD coefficient estimation module configured to update primary signal generation coefficients based on comparing a secondary predistorted signal ($U_{out}$) with a detected feedback signal ($Y_{out}$), and
a primary distortion compensation processing module configured to generate a primary predistorted signal

($U_{out}$') based on the secondary predistorted signal ($U_{out}$) using the updated primary signal generation coefficients; and

a secondary DPD layer comprising:

a signal characteristic estimation module configured to update secondary signal generation coefficients based on comparing an input signal ($S_{in}$) with the detected feedback signal ($Y_{out}$), and
a secondary distortion compensation processing module configured to generate the secondary predistorted signal ($U_{out}$) based on the input signal ($S_{in}$) using the updated secondary signal generation coefficients,

wherein preferably the primary DPD layer is configured to update the primary signal generation coefficients by performing direct or indirect learning, and the secondary DPD layer is configured to update the secondary signal generation coefficients by performing direct learning,

2. The system of claim 1, wherein the direct learning includes:

comparing the input signal ($S_{in}$) with an output signal ($S_{out}$) from an amplifier to determine a difference between the input and output signals; and
applying inverse modeling to update the primary or secondary signal generation coefficients in order to reduce the difference between the input and output signals.

3. The system of claim 1 or 2, wherein the indirect learning includes:

comparing the input signal ($S_{in}$) with an output signal ($S_{out}$) from an amplifier to determine an error signal;
decomposing the error signal into nonlinear terms; and
applying adaptive model learning to update the primary signal generation coefficients by subtracting the nonlinear terms of the error signal from the secondary predistorted signal ($U_{out}$).

4. A method comprising:

updating, by a signal characteristic estimation module of a secondary digital predistortion (DPD) layer, secondary signal generation coefficients based on comparing an input signal ($S_{in}$) with a detected feedback signal ($Y_{out}$);
generating, by a secondary distortion compensation processing module of the secondary DPD layer, a secondary predistorted signal ($U_{out}$) based on the input signal ($S_{in}$) using the updated secondary signal generation coefficients;
updating, by a DPD coefficient estimation module of a primary DPD layer, primary signal generation coefficients based on comparing the secondary predistorted signal ($U_{out}$) with the detected feedback signal ($Y_{out}$), and
generating, by a primary distortion compensation processing module of the primary DPD layer, a primary predistorted signal ($U_{out}$') based on the secondary predistorted signal ($U_{out}$) using the updated primary signal generation coefficients,
wherein preferably the primary signal generation coefficients are updated by performing direct or indirect learning, and the secondary signal generation coefficients are updated by performing indirect learning,

5. The method of claim 5, wherein the direct learning is performed by:

comparing the input signal ($S_{in}$) with an output signal ($S_{out}$) from an amplifier to determine a difference between the input and output signals; and
applying inverse modeling to update the primary or secondary signal generation coefficients in order to reduce the difference between the input and output signals.

6. The method of claim 4 or 5, wherein the indirect learning is performed by:

comparing the input signal ($S_{in}$) with an output signal ($S_{out}$) from an amplifier to determine an error signal;
decomposing the error signal into nonlinear terms; and
applying adaptive model learning to update the primary signal generation coefficients by subtracting the nonlinear terms of the error signal from the secondary predistorted signal ($U_{out}$).

7. A transmitter system comprising:

an intermodulation distortion filter module configured to filter a detected feedback signal ($Y_{in}$) to generate a targeted filtered signal ($Y_{out}$);
a primary digital predistortion (DPD) layer comprising:

a DPD coefficient estimation module configured to update primary signal generation coefficients based on comparing a secondary predistorted signal ($U_{out}$) with a targeted filtered signal ($Y_{out}$), and
a primary distortion compensation processing module configured to generate a primary predistorted signal ($U_{out}$') based on the secondary predistorted signal ($U_{out}$) using the updated primary signal generation coefficients; and

a secondary DPD layer comprising:

a signal characteristic estimation module configured to update secondary signal generation coefficients based on comparing an input signal ($S_{in}$) with a targeted filtered signal ($Y_{out}$), and
a secondary distortion compensation processing module configured to generate the secondary predistorted signal ($U_{out}$) based on the input signal ($S_{in}$) using the updated secondary signal generation coefficients,

wherein preferably the primary DPD layer is configured to update the primary signal generation coefficients by performing direct or indirect learning, and the secondary DPD layer is configured to update the secondary signal generation coefficients by performing indirect learning.

8. A method comprising:

filtering, by an intermodulation distortion filter module, a detected feedback signal ($Y_{in}$) to generate a targeted filtered signal ($Y_{out}$);
updating, by a signal characteristic estimation module of a secondary digital predistortion (DPD) layer, secondary signal generation coefficients based on comparing an input signal ($S_{in}$) with a targeted feedback signal ($Y_{out}$);
generating, by a secondary distortion compensation processing module of the secondary DPD layer, a secondary predistorted signal ($U_{out}$) based on the input signal ($S_{in}$) using the updated secondary signal generation coefficients;
updating, by a DPD coefficient estimation module of a primary DPD layer, primary signal generation coefficients based on comparing the secondary predistorted signal ($U_{out}$) with the targeted feedback signal ($Y_{out}$), and
generating, by a primary distortion compensation processing module of the primary DPD layer, a primary predistorted signal ($U_{out}$') based on the secondary predistorted signal ($U_{out}$) using the updated primary signal generation coefficients,
wherein preferably the primary signal generation coefficients are updated by performing direct or indirect learning, and the secondary signal generation coefficients are updated by performing indirect learning.

9. A non-transitory computer-readable medium storing instructions therein which, when run on a processor, causes the processor to carry out the method of one of claims 4 to 6 and 8.

10. A transmitter system comprising:

a signal decomposition module configured to extract a low-frequency input signal ($S_{lo}$) and a high-frequency input signal ($S_{hi}$) from an input signal ($S_{in}$);
a low-frequency primary digital predistortion (DPD) layer comprising:

a low-frequency DPD coefficient estimation module configured to update low-frequency primary signal generation coefficients based on a low-frequency secondary predistorted signal ($U_{lo}$), a high-frequency secondary predistorted signal ($U_{hi}$), and a low-frequency detected feedback signal ($Y_{lo}$), and
a low-frequency primary distortion compensation processing module configured to generate a low-frequency primary predistorted signal ($U_{lo}$') based on the low-frequency secondary predistorted signal ($U_{lo}$) and a high-frequency secondary predistorted signal ($U_{hi}$) using the updated low-frequency primary signal generation coefficients;

a high-frequency primary DPD layer comprising:

a high-frequency DPD coefficient estimation module configured to update high-frequency primary signal generation coefficients based on the low-frequency secondary predistorted signal ($U_{lo}$), the high-frequency secondary predistorted signal ($U_{hi}$), and a high-frequency detected feedback signal ($Y_{hi}$), and

a high-frequency primary distortion compensation processing module configured to generate a high-frequency primary predistorted signal ($U_{hi}'$) based on the low-frequency secondary predistorted signal ($U_{lo}$) and the high-frequency secondary predistorted signal ($U_{hi}$) using the updated high-frequency primary signal generation coefficients;

a signal combining module configured to combine the low-frequency primary predistorted signal ($U_{lo}'$) and the high-frequency primary predistorted signal ($U_{hi}'$);

a low-frequency secondary DPD layer comprising:

a low-frequency signal characteristic estimation module configured to update low-frequency secondary signal generation coefficients based on the low-frequency input signal ($S_{lo}$), the high-frequency input signal ($S_{hi}$), and the detected low-frequency feedback signal ($Y_{lo}$), and

a low-frequency secondary distortion compensation processing module configured to generate the low-frequency secondary predistorted signal ($U_{lo}$) based on the low-frequency input signal ($S_{lo}$) and the high-frequency input signal ($S_{hi}$) using the updated low-frequency secondary signal generation coefficients; and

a high-frequency secondary DPD layer comprising:

a high-frequency signal characteristic estimation module configured to update high-frequency secondary signal generation coefficients based on the low-frequency input signal ($S_{lo}$), the high-frequency input signal ($S_{hi}$), and the detected high-frequency feedback signal ($Y_{hi}$), and

a high-frequency secondary distortion compensation processing module configured to generate the high-frequency secondary predistorted signal ($U_{hi}$) based on the low-frequency input signal ($S_{lo}$) and the high-frequency input signal ($S_{hi}$) using the updated high-frequency secondary signal generation coefficients.

**11.** A method comprising:

extracting, by a signal decomposition module, a low-frequency input signal ($S_{lo}$) and a high-frequency input signal ($S_{hi}$) from an input signal ($S_{in}$);

updating, by a low-frequency signal characteristic estimation module of a low-frequency secondary digital predistortion (DPD) layer, low-frequency secondary signal generation coefficients based on the low-frequency input signal ($S_{lo}$), the high-frequency input signal ($S_{hi}$), and a low-frequency detected feedback signal ($Y_{lo}$);

generating, by a low-frequency secondary distortion compensation processing module of the low-frequency secondary DPD layer, a low-frequency secondary predistorted signal ($U_{lo}$) based on the low-frequency input signal ($S_{lo}$) and the high-frequency input signal ($S_{hi}$) using the updated low-frequency secondary signal generation coefficients;

updating, by a high-frequency signal characteristic estimation module of a high-frequency secondary DPD layer, high-frequency secondary signal generation coefficients based on the low-frequency input signal ($S_{lo}$), the high-frequency input signal ($S_{hi}$), and a high-frequency detected feedback signal ($Y_{hi}$);

generating, by a high-frequency secondary distortion compensation processing module of the high-frequency secondary DPD layer, a high-frequency secondary predistorted signal ($U_{hi}$) based on the low-frequency input signal ($S_{lo}$) and the high-frequency input signal ($S_{hi}$) using the updated high-frequency secondary signal generation coefficients;

updating, by a low-frequency DPD coefficient estimation module of a low-frequency primary DPD layer, low-frequency primary signal generation coefficients based on a low-frequency secondary predistorted signal ($U_{lo}$), a high-frequency secondary predistorted signal ($U_{hi}$), and the low-frequency detected feedback signal ($Y_{lo}$);

generating, by a low-frequency primary distortion compensation processing module of the low-frequency primary DPD layer, a low-frequency primary predistorted signal ($U_{lo}'$) based on the low-frequency secondary predistorted signal ($U_{lo}$) and a high-frequency secondary predistorted signal ($U_{hi}$) using the updated low-frequency primary signal generation coefficients;

updating, by a high-frequency DPD coefficient estimation module of a high-frequency primary DPD layer, high-frequency primary signal generation coefficients based on the low-frequency secondary predistorted signal ($U_{lo}$), the high-frequency secondary predistorted signal ($U_{hi}$), and the high-frequency detected feedback signal ($Y_{hi}$);

generating, by a high-frequency primary distortion compensation processing module of the high-frequency primary DPD layer, a high-frequency primary predistorted signal ($U_{hi}'$) based on the low-frequency secondary

predistorted signal ($U_{lo}$) and the high-frequency secondary predistorted signal ($U_{hi}$) using the updated high-frequency primary signal generation coefficients; and

combining, by a signal combining module, the low-frequency primary predistorted signal ($U_{lo}$') and the high-frequency primary predistorted signal ($U_{hi}$').

12. A non-transitory computer-readable medium storing instructions therein which, when run on a processor, causes the processor to carry out the method of claim 11.

13. A transmitter system comprising:

a signal decomposition module configured to extract a low-frequency input signal ($S_{lo}$) and a high-frequency input signal ($S_{hi}$) from an input signal ($S_{in}$);

a low-frequency intermodulation distortion filter module configured to filter a detected low-frequency feedback signal ($Y_{lo}$) to generate a targeted low-frequency filtered signal ($Y_{lo}$');

a high-frequency intermodulation distortion filter module configured to filter a detected high-frequency feedback signal ($Y_{hi}$) to generate a targeted high-frequency filtered signal ($Y_{hi}$');

a low-frequency primary digital predistortion (DPD) layer comprising:

a low-frequency DPD coefficient estimation module configured to update low-frequency primary signal generation coefficients based on a low-frequency secondary predistorted signal ($U_{lo}$), a high-frequency secondary predistorted signal ($U_{hi}$), and the targeted low-frequency filtered signal ($Y_{lo}$'), and

a low-frequency primary distortion compensation processing module configured to generate a low-frequency primary predistorted signal ($U_{lo}$') based on the low-frequency secondary predistorted signal ($U_{lo}$) and a high-frequency secondary predistorted signal ($U_{hi}$) using the updated low-frequency primary signal generation coefficients;

a high-frequency primary DPD layer comprising:

a high-frequency DPD coefficient estimation module configured to update high-frequency primary signal generation coefficients based on the low-frequency secondary predistorted signal ($U_{lo}$), the high-frequency secondary predistorted signal ($U_{hi}$), and the targeted high-frequency filtered signal ($Y_{hi}$'), and

a high-frequency primary distortion compensation processing module configured to generate a high-frequency primary predistorted signal ($U_{hi}$') based on the low-frequency secondary predistorted signal ($U_{lo}$) and the high-frequency secondary predistorted signal ($U_{hi}$) using the updated high-frequency primary signal generation coefficients;

a signal combining module configured to combine the low-frequency primary predistorted signal ($U_{lo}$') and the high-frequency primary predistorted signal ($U_{hi}$');

a low-frequency secondary DPD layer comprising:

a low-frequency signal characteristic estimation module configured to update low-frequency secondary signal generation coefficients based on the low-frequency input signal ($S_{lo}$), the high-frequency input signal ($S_{hi}$), and the targeted low-frequency filtered signal ($Y_{lo}$'), and

a low-frequency secondary distortion compensation processing module configured to generate the low-frequency secondary predistorted signal ($U_{lo}$) based on the low-frequency input signal ($S_{lo}$) and the high-frequency input signal ($S_{hi}$) using the updated low-frequency secondary signal generation coefficients; and

a high-frequency secondary DPD layer comprising:

a high-frequency signal characteristic estimation module configured to update high-frequency secondary signal generation coefficients based on the low-frequency input signal ($S_{lo}$), the high-frequency input signal ($S_{hi}$), and the targeted high-frequency filtered signal ($Y_{hi}$'), and

a high-frequency secondary distortion compensation processing module configured to generate the high-frequency secondary predistorted signal ($U_{hi}$) based on the low-frequency input signal ($S_{lo}$) and the high-frequency input signal ($S_{hi}$) using the updated high-frequency secondary signal generation coefficients.

14. A method comprising:

extracting, by a signal decomposition module, a low-frequency input signal ($S_{lo}$) and a high-frequency input signal ($S_{hi}$) from an input signal ($S_{in}$);

generating, by a low-frequency intermodulation distortion filter module, a targeted low-frequency filtered signal ($Y_{lo}'$) by filtering a detected low-frequency feedback signal ($Y_{lo}$);

generating, by a high-frequency intermodulation distortion filter module, a targeted high-frequency filtered signal ($Y_{hi}'$) by filtering a detected high-frequency feedback signal ($Y_{hi}$);

updating, by a low-frequency signal characteristic estimation module of a low-frequency secondary digital predistortion (DPD) layer, low-frequency secondary signal generation coefficients based on the low-frequency input signal ($S_{lo}$), the high-frequency input signal ($S_{hi}$), and the targeted low-frequency filtered signal ($Y_{lo}'$);

generating, by a low-frequency secondary distortion compensation processing module of the low-frequency secondary DPD layer, a low-frequency secondary predistorted signal ($U_{lo}$) based on the low-frequency input signal ($S_{lo}$) and the high-frequency input signal ($S_{hi}$) using the updated low-frequency secondary signal generation coefficients;

updating, by a high-frequency signal characteristic estimation module of a high-frequency secondary DPD layer, high-frequency secondary signal generation coefficients based on the low-frequency input signal ($S_{lo}$), the high-frequency input signal ($S_{hi}$), and the targeted high-frequency filtered signal ($Y_{hi}'$);

generating, by a high-frequency secondary distortion compensation processing module of the high-frequency secondary DPD layer, a high-frequency secondary predistorted signal ($U_{hi}$) based on the low-frequency input signal ($S_{lo}$) and the high-frequency input signal ($S_{hi}$) using the updated high-frequency secondary signal generation coefficients;

updating, by a low-frequency DPD coefficient estimation module of a low-frequency primary DPD layer, low-frequency primary signal generation coefficients based on the low-frequency secondary predistorted signal ($U_{lo}$), the high-frequency secondary predistorted signal ($U_{hi}$), and the targeted low-frequency filtered signal ($Y_{lo}'$);

generating, by a low-frequency primary distortion compensation processing module of the low-frequency primary DPD layer, a low-frequency primary predistorted signal ($U_{lo}'$) based on the low-frequency secondary predistorted signal ($U_{lo}$) and the high-frequency secondary predistorted signal ($U_{hi}$) using the updated low-frequency primary signal generation coefficients;

updating, by a high-frequency DPD coefficient estimation module of a high-frequency primary DPD layer, high-frequency primary signal generation coefficients based on the low-frequency secondary predistorted signal ($U_{lo}$), the high-frequency secondary predistorted signal ($U_{hi}$), and the targeted high-frequency filtered signal ($Y_{hi}'$);

generating, by a high-frequency primary distortion compensation processing module of the high-frequency primary digital predistortion layer, a high-frequency primary predistorted signal ($U_{hi}'$) based on the low-frequency secondary predistorted signal ($U_{lo}$) and the high-frequency secondary predistorted signal ($U_{hi}$) using the updated high-frequency primary signal generation coefficients; and

combining, by a signal combining module, the low-frequency primary predistorted signal ($U_{lo}'$) and the high-frequency primary predistorted signal ($U_{hi}'$).

15. A non-transitory computer-readable medium storing instructions therein which, when run on a processor, causes the processor to carry out the method of claim 14.

**Fig.1**

100

(Prior Art)

114

Signal Source 102 → $S_{in}$ → Predistorter 104 → DAC 106 → IQ-mod 108 → PA 112 → $S_{out}$

Local Oscillator 110

Parameter Identification 120 ← ADC 118 ← IQ-demod 116

**Fig.2**

*Fig.3A*

## Fig.3B

304

```
Yout ← ┌─────────────────────┐ ← ┌─────────────────┐ ← Yin
        │ Targeted IMD/Spectrum │   │   Gain Mask       │
        │Emission Processing Unit│   │ Processing Unit   │
        │         312           │   │      308          │
        └─────────────────────┘   └─────────────────┘
                  ↑                         ↑
        ┌─────────────────────┐   ┌─────────────────┐
        │   Filter Design      │   │   Gain Mask       │
        │  Generating Unit     │   │ Generating Unit   │
        │         314          │   │      310          │
        └─────────────────────┘   └─────────────────┘
```

Fig.4A

EP 4 191 873 A1

**Fig.4B**

EP 4 191 873 A1

**Fig.5**

**Fig.6**

EP 4 191 873 A1

## *Fig.7A*

```
                          ( Start )                    700
                              │                         ↙
                              │                              701
                              ▼                          ↙
┌─────────────────────────────────────────────────────────────────┐
│ Generate primary pre-distorted signal (U_out') based on input    │
│ signal (S_in) using primary signal generation coefficients       │
└─────────────────────────────────────────────────────────────────┘
                              │                              702
                              │                          ↙
                              ▼
┌─────────────────────────────────────────────────────────────────┐
│ Update secondary signal generation coefficients of secondary DPD │
│ layer (204) based on comparing input signal (S_in) with detected │
│ feedback signal (Y_out)                                          │
└─────────────────────────────────────────────────────────────────┘
                              │                              704
                              │                          ↙
                              ▼
┌─────────────────────────────────────────────────────────────────┐
│ Generate secondary pre-distorted signal (U_out) based on input   │
│ signal (S_in) using updated secondary signal generation          │
│ coefficients                                                     │
└─────────────────────────────────────────────────────────────────┘
                              │                              706
                              │                          ↙
                              ▼
┌─────────────────────────────────────────────────────────────────┐
│ Update primary signal generation coefficients of primary DPD     │
│ layer (202) based on comparing secondary pre-distorted signal    │
│ (U_out) with detected feedback signal (Y_out)                    │
└─────────────────────────────────────────────────────────────────┘
                              │                              708
                              │                          ↙
                              ▼
┌─────────────────────────────────────────────────────────────────┐
│ Generate primary pre-distorted signal (U_out') based on          │
│ secondary pre-distorted signal (U_out) using updated primary     │
│ signal generation coefficients                                   │
└─────────────────────────────────────────────────────────────────┘
                              │
                              ▼
                           ( End )
```

**701** Generate primary pre-distorted signal ($U_{out}'$) based on input signal ($S_{in}$) using primary signal generation coefficients

**702** Update secondary signal generation coefficients of secondary DPD layer (204) based on comparing input signal ($S_{in}$) with detected feedback signal ($Y_{out}$)

**704** Generate secondary pre-distorted signal ($U_{out}$) based on input signal ($S_{in}$) using updated secondary signal generation coefficients

**706** Update primary signal generation coefficients of primary DPD layer (202) based on comparing secondary pre-distorted signal ($U_{out}$) with detected feedback signal ($Y_{out}$)

**708** Generate primary pre-distorted signal ($U_{out}'$) based on secondary pre-distorted signal ($U_{out}$) using updated primary signal generation coefficients

*Fig.7B*

710

Start

712

Yes

End ← Distortion < Threshold?

No    714

Calculate DPD coefficients based on input signal and feedback signal

716

Generate predistorted signal using the updated coefficients

718

Send predistorted signal to PA module and receive feedback signal

# Fig.8

800

```
            ( Start )
                |
                v
```

801

Generate primary pre-distorted signal ($U_{out}'$) based on input signal ($S_{in}$) using primary signal generation coefficients

802

Filter detected feedback signal ($Y_{in}$) to generate targeted filtered signal ($Y_{out}$)

804

Update secondary signal generation coefficients of secondary DPD layer (204) based on comparing input signal ($S_{in}$) with targeted feedback signal ($Y_{out}$)

806

Generate secondary pre-distorted signal ($U_{out}$) based on input signal ($S_{in}$) using updated secondary signal generation coefficients

808

Update primary signal generation coefficients of primary DPD layer (202) based on comparing secondary pre-distorted signal ($U_{out}$) with targeted feedback signal ($Y_{out}$)

810

Generate primary pre-distorted signal ($U_{out}'$) based on secondary pre-distorted signal ($U_{out}$) using updated primary signal generation coefficients

```
            ( End )
```

# Fig.9

Start

900

```
  ┌─────────────────────────────────────────────────────────────────────────┐   902
  │ Extract low-frequency input signal (S_lo) and high-frequency input       │
  │ signal (S_hi) from input signal (S_in)                                   │
  └─────────────────────────────────────────────────────────────────────────┘
```

Extract low-frequency input signal ($S_{lo}$) and high-frequency input signal ($S_{hi}$) from input signal ($S_{in}$)

902

Generate low-frequency/high-frequency primary pre-distorted signal ($U_{lo}'$, $U_{hi}'$) based on low-frequency input signal ($S_{lo}$) and high-frequency input signal ($S_{hi}$) using low-frequency/high-frequency secondary signal generation coefficients, then combine

903

Update low-frequency/high-frequency secondary signal generation coefficients of low-frequency/high-frequency secondary DPD layer based on low-frequency input signal ($S_{lo}$), high-frequency input signal ($S_{hi}$), and low-frequency/high-frequency detected feedback signal ($Y_{lo}$, $Y_{hi}$)

904

Generate low-frequency/high-frequency secondary pre-distorted signals ($U_{lo}$, $U_{hi}$) based on low-frequency input signal ($S_{lo}$) and high-frequency input signal ($S_{hi}$) using updated low-frequency/high-frequency secondary signal generation coefficients

906

Update low-frequency/high-frequency primary signal generation coefficients of low-frequency/high-frequency primary DPD layer based on low-frequency secondary pre-distorted signal ($U_{lo}$), high-frequency secondary pre-distorted signal ($U_{hi}$), and low-frequency/high-frequency detected feedback signal ($Y_{lo}$, $Y_{hi}$)

908

Generate low-frequency/high-frequency primary pre-distorted signal ($U_{lo}'$, $U_{hi}'$) based on low-frequency secondary pre-distorted signal ($U_{lo}$) and high-frequency secondary pre-distorted signal ($U_{hi}$) using updated low-frequency/high-frequency primary signal generation coefficients

910

Combine low-frequency primary pre-distorted signal ($U_{lo}'$) and high-frequency primary pre-distorted signal ($U_{hi}'$)

912

End

# Fig.10

1000

```
( Start )
```

↓

Extract low-frequency input signal ($S_{lo}$) and high-frequency input signal ($S_{hi}$) from input signal ($S_{in}$)  —— 1002

↓

Generate low-frequency/high-frequency primary pre-distorted signal ($U_{lo}'$, $U_{hi}'$) based on low-frequency/high-frequency input signals ($S_{lo}$, $S_{hi}$) using low-frequency/high-frequency primary signal generation coefficients, then combine  —— 1003

↓

Generate targeted low-frequency filtered signal ($Y_{lo}'$) by filtering detected low-frequency feedback signal ($Y_{lo}$) and targeted high-frequency filtered signal ($Y_{hi}'$) by filtering detected high-frequency feedback signal ($z_{hi}$)  —— 1004

↓

Update low-frequency/high-frequency secondary signal generation coefficients based on low-frequency input signal ($S_{lo}$), high-frequency input signal ($S_{hi}$), and targeted low-frequency/high-frequency filtered signal ($Y_{lo}'$, $Y_{hi}'$)  —— 1006

↓

Generate low-frequency/high-frequency secondary pre-distorted signal ($U_{lo}$, $U_{hi}$) based on low-frequency input signal ($S_{lo}$) and high-frequency input signal ($S_{hi}$) using updated low-frequency/high-frequency secondary signal generation coefficients  —— 1008

↓

Update low-frequency/high-frequency primary signal generation coefficients based on low-frequency/high-frequency secondary pre-distorted signal ($U_{lo}$), high-frequency secondary pre-distorted signal ($U_{hi}$), and targeted low-frequency/high-frequency filtered signal ($Y_{lo}'$, $Y_{hi}'$)  —— 1010

↓

Generate low-frequency/high-frequency primary pre-distorted signal ($U_{lo}'$, $U_{hi}'$) based on low-frequency secondary pre-distorted signal ($U_{lo}$) and high-frequency secondary pre-distorted signal ($U_{hi}$) using updated low-frequency/high-frequency primary signal generation coefficients  —— 1012

↓

Combine low-frequency primary pre-distorted signal ($U_{lo}'$) and high-frequency primary pre-distorted signal ($U_{hi}'$)  —— 1014

↓

```
( End )
```

EP 4 191 873 A1

# Fig.11

1100

Gain High End (dB)

0

0

Normalized Gain Mask Frequency (MHz)

*Fig.12*

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LE DUC HAN ET AL: "An Adaptive Cascaded ILA- and DLA-Based Digital Predistorter for Linearizing an RF Power Amplifier", IEEE TRANSACTIONS ON CIRCUITS AND SYSTEMS I: REGULAR PAPERS, IEEE, US, vol. 66, no. 3, 1 March 2019 (2019-03-01), pages 1031-1041, XP011708911, ISSN: 1549-8328, DOI: 10.1109/TCSI.2018.2872465 [retrieved on 2019-02-04] | 1-15 | INV. H03F1/32 |
| Y | * figures 1-4 * * page 1031, left-hand column, line 1 – page 1040, right-hand column, line 3 * | 10-15 | |
| X | SHEN YIJUN ET AL: "Adaptive predistortion algorithm based on the multilinear multiplier fusion : Adaptive Predistortion Algorithm Based on the Multilinear Multiplier Fusion", CONCURRENCY AND COMPUTATION: PRACTICE AND EXPERIENCE, vol. 30, no. 22, 25 November 2018 (2018-11-25), page e4645, XP055790465, GB ISSN: 1532-0626, DOI: 10.1002/cpe.4645 | 1-15 | |
| | | | **TECHNICAL FIELDS SEARCHED (IPC)** |
| | | | H03F |
| Y | * figures 2-4 * * page 3, last paragraph – page 8, first paragraph * | 10-15 | |
| X | US 2021/328553 A1 (MOCHIDA EIJI [JP]) 21 October 2021 (2021-10-21) | 1-15 | |
| Y | * figures 1-14 * * paragraphs [0001] – [0146] * | 10-15 | |

-/--

The present search report has been drawn up for all claims

| Place of search | Date of completion of the search | Examiner |
|---|---|---|
| The Hague | 18 April 2023 | Jespers, Michaël |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

**EP 22 21 1638**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CAO TAO ET AL: "Frequency Multiplier-Based Millimeter-Wave Vector Signal Transmitter Using Digital Predistortion With Constrained Feedback Bandwidth", IEEE TRANSACTIONS ON MICROWAVE THEORY AND TECHNIQUES, IEEE, USA, vol. 68, no. 5, 10 January 2020 (2020-01-10), pages 1819-1829, XP011787006, ISSN: 0018-9480, DOI: 10.1109/TMTT.2019.2961085 [retrieved on 2020-05-05] | 1-15 | |
| Y | * figures 1-5 * * page 1819, left-hand column, line 1 - page 1827, right-hand column, line 5 * ----- | 10-15 | |
| Y | US 2015/049841 A1 (LAPORTE PIERRE-ANDRE [CA] ET AL) 19 February 2015 (2015-02-19) | 10-15 | |
| A | * figures 1-12 * * paragraphs [0001] - [0079] * ----- | 1-9 | TECHNICAL FIELDS SEARCHED (IPC) |
| Y | EP 3 005 553 B1 (ERICSSON TELEFON AB L M [SE]) 14 August 2019 (2019-08-14) | 10-15 | |
| A | * figures 1-6 * * paragraphs [0001] - [0062] * ----- | 1-9 | |

The present search report has been drawn up for all claims

| Place of search | Date of completion of the search | Examiner |
|---|---|---|
| The Hague | 18 April 2023 | Jespers, Michaël |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.....................................................................
& : member of the same patent family, corresponding document

EPO FORM 1503 03.82 (P04C01)

EP 4 191 873 A1

## ANNEX TO THE EUROPEAN SEARCH REPORT
## ON EUROPEAN PATENT APPLICATION NO.

EP 22 21 1638

This annex lists the patent family members relating to the patent documents cited in the above-mentioned European search report.
The members are as contained in the European Patent Office EDP file on
The European Patent Office is in no way liable for these particulars which are merely given for the purpose of information.

18-04-2023

| Patent document cited in search report | | | Publication date | Patent family member(s) | | | Publication date |
|---|---|---|---|---|---|---|---|
| US 2021328553 | A1 | | 21-10-2021 | CN | 112567628 | A | 26-03-2021 |
| | | | | JP | WO2020044831 | A1 | 09-09-2021 |
| | | | | US | 2021328553 | A1 | 21-10-2021 |
| | | | | WO | 2020044831 | A1 | 05-03-2020 |
| US 2015049841 | A1 | | 19-02-2015 | CN | 105229927 | A | 06-01-2016 |
| | | | | EP | 3000180 | A2 | 30-03-2016 |
| | | | | US | 2015049841 | A1 | 19-02-2015 |
| | | | | WO | 2014188294 | A2 | 27-11-2014 |
| EP 3005553 | B1 | | 14-08-2019 | AR | 096412 | A1 | 30-12-2015 |
| | | | | EP | 3005553 | A1 | 13-04-2016 |
| | | | | US | 2014348263 | A1 | 27-11-2014 |
| | | | | US | 2015163079 | A1 | 11-06-2015 |
| | | | | US | 2016119004 | A1 | 28-04-2016 |
| | | | | WO | 2014188316 | A1 | 27-11-2014 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LEI et al.** A Robust Digital Baseband Predistorter Constructed Using Memory Polynomials. *IEEE Transactions on Communications,* vol. 52 (1), 159-165